(19) Europäisches Patentamt
European Patent Office
Office européen des brevets

(11) EP 4 661 635 A1

(12) EUROPEAN PATENT APPLICATION
published in accordance with Art. 153(4) EPC

(43) Date of publication:
**10.12.2025 Bulletin 2025/50**

(21) Application number: **24750202.4**

(22) Date of filing: **29.01.2024**

(51) International Patent Classification (IPC):
***H10K 50/13*** *(2023.01)* ***G09F 9/30*** *(2006.01)*
***H10K 50/12*** *(2023.01)* ***H10K 50/125*** *(2023.01)*
***H10K 50/15*** *(2023.01)* ***H10K 50/16*** *(2023.01)*
***H10K 50/18*** *(2023.01)* ***H10K 59/10*** *(2023.01)*
***H10K 59/12*** *(2023.01)* ***H10K 85/60*** *(2023.01)*
***H10K 101/30*** *(2023.01)* ***H10K 101/40*** *(2023.01)*

(52) Cooperative Patent Classification (CPC):
**G09F 9/30; H10K 50/12; H10K 50/125; H10K 50/13; H10K 50/15; H10K 50/16; H10K 50/18; H10K 59/10; H10K 59/12; H10K 85/60;** H10K 2101/30; H10K 2101/40

(86) International application number:
**PCT/JP2024/002634**

(87) International publication number:
**WO 2024/162253 (08.08.2024 Gazette 2024/32)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **03.02.2023 JP 2023015298**
**29.08.2023 JP 2023139102**

(71) Applicant: **Canon Kabushiki Kaisha**
**Tokyo, 146-8501 (JP)**

(72) Inventors:
- **NISHIDE, Yosuke**
**Tokyo 146-8501 (JP)**
- **ITO, Takayuki**
**Tokyo 146-8501 (JP)**
- **OHRUI, Hiroki**
**Tokyo 146-8501 (JP)**
- **YAMADA, Naoki**
**Tokyo 146-8501 (JP)**

(74) Representative: **TBK**
**Bavariaring 4-6**
**80336 München (DE)**

(54) **ORGANIC LIGHT EMITTING ELEMENT**

(57) The present disclosure provides an organic light-emitting element including a first light-emitting layer that includes a first organic compound, a first light-emitting material, and a second light-emitting material and including a second light-emitting layer that includes a second organic compound and a third light-emitting material, wherein the hole-trapping ability of the first light-emitting layer is mitigated and the recombination region of holes and electrons is kept away from the electrode side of the first light-emitting layer and is also localized in the light-emitting layer by controlling the difference between the HOMO levels of the first light-emitting material and first organic compound in the first light-emitting layer to be smaller than the difference between the LUMO levels of the second organic compound and third light-emitting material in the second light-emitting layer, and reducing the content of the light-emitting material in the first light-emitting layer.

EP 4 661 635 A1

## Description

### Technical Field

The present invention relates to an organic light-emitting element and various equipment and apparatuses including the organic light-emitting element.

### Background Art

An organic light-emitting element (also referred to as "organic electroluminescence element" or "organic EL element" in some cases) is an element that includes a positive electrode, a negative electrode, and an organic compound layer disposed between these electrodes and including a light-emitting layer, and emits light by energizing the organic compound layer. The organic light-emitting element is used in various display apparatuses because of its characteristics of a high degree of freedom in shape, lightweight, and a high color rendering property, compared to known display apparatuses. As one of this technology, full color displays using organic light-emitting elements are known. The systems thereof includes a system of emitting light with different colors by creating light-emitting layers for each pixel (element) and a system including a light-emitting layer for emitting white light and extracting light with different colors for each pixel using color filters. Regarding the white light-emitting layer, it is known to use two or more light-emitting materials and use a light-emitting layer composed of two or more layers.

In recent years, development for evolving further application products is being actively carried out, in particular, technology to improve the driving durability of organic white light-emitting elements is being required.

PTL 1 describes an organic light-emitting element including two stacked light-emitting layers, in which the light-emitting layer on the negative electrode side contains 0.6 mass% of a blue light-emitting dopant, and the light-emitting layer on the positive electrode side contains a red light-emitting dopant and 2.0 mass% of a green light-emitting dopant.

### Citation List

#### Patent Literature

PTL 1: Japanese Patent Laid-Open No. 2019-186521

### Summary of Invention

#### Technical Problem

PTL 1 describes a configuration of an organic white light-emitting element including blue, green, and red light-emitting dopants, but there are rooms for improving the concentrations of the light-emitting dopants and the resulting charge balance in the light-emitting layers. Solution to Problem

In view of the above problems, the present invention aims to improve the light emission characteristic and driving durability characteristic in an organic light-emitting element including two light-emitting layers.

A first organic light-emitting element of the present invention is an organic light-emitting element including a first electrode, a first light-emitting layer, a second light-emitting layer, and a second electrode in this order, wherein the first light-emitting layer includes a first organic compound, a first light-emitting material, and a second light-emitting material, the second light-emitting layer includes a second organic compound and a third light-emitting material, and the following expressions [1] to [4] are satisfied:

$$[1]\ (HOMOd2 - HOMOh1) < (LUMOh2 - LUMOd3);$$

the content of the first light-emitting material < the content of the second light-emitting material; [2]

the content of the first light-emitting material < the content of the third light-emitting material; [3]

and

the content of the second light-emitting material < 2.0 mass%, [4]

HOMOh1: the HOMO level of the first organic compound;
HOMOd2: the HOMO level of the second light-emitting material;
LUMOh2: the LUMO level of the second organic compound; and
LUMOd3: the LUMO level of the third light-emitting material.

A second organic light-emitting element of the present invention includes a first electrode, a first light-emitting layer, a second light-emitting layer, an adjacent layer, and a second electrode in this order, wherein the first light-emitting layer includes a first organic compound, a first light-emitting material, and a second light-emitting material, the second light-emitting layer includes a second organic compound and a third light-emitting material, the adjacent layer is made of an organic compound composed of hydrocarbon, and the following expression [4] is satisfied:

the content of the second light-emitting material < 2.0 mass%. [4]

Advantageous Effects of Invention

According to the present invention, in an organic light-emitting element including two or more light-emitting layers, the light emission characteristic and the driving durability characteristic can be improved.

Brief Description of Drawings

[Fig. 1A] Fig. 1A is a schematic cross-sectional view illustrating an example of a pixel of a display apparatus according to one embodiment of the present invention.
[Fig. 1B] Fig. 1B is a schematic cross-sectional view of an example of a display apparatus using an organic light-emitting element according to one embodiment of the present invention.
[Fig. 2] Fig. 2 is a schematic view illustrating an example of a display apparatus according to one embodiment of the present invention.
[Fig. 3A] Fig. 3A is a schematic view of an image pickup apparatus according to one embodiment of the present invention.
[Fig. 3B] Fig. 3B is a schematic view of electronic equipment according to one embodiment of the present invention.
[Fig. 4A] Fig. 4A is a schematic view of a display apparatus according to one embodiment of the present invention.
[Fig. 4B] Fig. 4B is a schematic view of a foldable display apparatus according to one embodiment of the present invention.
[Fig. 5A] Fig. 5A is a schematic view of an illuminating apparatus according to one embodiment of the present invention.
[Fig. 5B] Fig. 5B is a schematic view of an automobile having a vehicle lighting device according to one embodiment of the present invention.
[Fig. 6A] Fig. 6A is a schematic view of a wearable device according to one embodiment of the present invention.
[Fig. 6B] Fig. 6B is a schematic view illustrating an example of a wearable device according to one embodiment of the present invention in a form of having an image pickup apparatus.
[Fig. 7A] Fig. 7A is a schematic view of an image formation apparatus according to one embodiment of the present invention.
[Fig. 7B] Fig. 7B is a schematic view illustrating a configuration in which a plurality of light-emitting units of an exposure light source is arranged on a long substrate.
[Fig. 7C] Fig. 7C is a schematic view illustrating a configuration in which a plurality of light-emitting units of an exposure light source is arranged on a long substrate.

Description of Embodiments

A first organic light-emitting element of the present invention includes a first electrode, a first light-emitting layer, a second light-emitting layer, and a second electrode in this order, wherein the first light-emitting layer includes a first organic compound, a first light-emitting material, and a second light-emitting material, the second light-emitting layer includes a second organic compound and a third light-emitting material, and the following expressions [1] to [4] are satisfied:

$$[1]\ (HOMOd2 - HOMOh1) < (LUMOh2 - LUMOd3);$$

the content of the first light-emitting material < the content of the second light-emitting material; [2]

the content of the first light-emitting material < the content of the third light-emitting material; [3]

and

the content of the second light-emitting material < 2.0 mass%, [4]

HOMOh1: the HOMO level of the first organic compound;
HOMOd2: the HOMO level of the second light-emitting material;
LUMOh2: the LUMO level of the second organic compound; and
LUMOd3: the LUMO level of the third light-emitting material.

The features of the light-emitting layer of an organic light-emitting element of the present invention will now be described.

In order to achieve improvements of the light emission characteristic and driving durability of the organic light-emitting element, it is necessary that both injected holes and electrons are confined in the light-emitting layer and are efficiently recombined. That is, it is necessary to reduce leakage of holes in the light-emitting layer to the layer on the negative electrode side and leakage of electrons in the light-emitting layer to the layer on the positive electrode side. In addition, it is preferable for improving the durability characteristic that a charge recombination region is delocalized in the light-emitting layer. It is because that the excitation load per molecule is reduced and that deterioration from the excited state is suppressed.

In order to confine holes and electrons in the light-emitting layer, it is effective to dispose an electron-blocking layer on the positive electrode side of the light-emitting layer and a hole-blocking layer on the negative electrode side. Examples of the constituent material of the electron-blocking layer include an arylamine derivative having a nitrogen-containing skeleton that is highly electron donating. Although such a derivative has a high hole-transporting ability, the radical anion stability is low. Accordingly, it has been demonstrated that the durability characteristic of an organic light-emitting element is improved by keeping the recombination region away from the interface between the light-emitting layer and the electron-blocking layer to suppress transportation of electrons or excitation by recombination at the interface.

Accordingly, in the present invention, holes are efficiently trapped in the first light-emitting layer and electrons are efficiently trapped in the second light-emitting layer, and thereby charges are confined in both light-emitting layers, and at the same time, the recombination region is delocalized. Furthermore, the hole-trapping ability of the first light-emitting layer is mitigated by decreasing the content of the light-emitting material in the first light-emitting layer, and even when layers including an arylamine derivative, such as an electron-blocking layer and a hole injection layer, are disposed on the first electrode side of the first light-emitting layer, deterioration of these layers is suppressed by keeping the recombination region away from the first electrode side interface of the first light-emitting layer. Accordingly, the durability characteristic of the organic light-emitting element is improved.

The expression [1] that is a characteristic of the present invention shows that the hole-trapping ability of the first light-emitting layer is lower than the electron-trapping ability of the second light-emitting layer. The HOMO level of the light-emitting material of the light-emitting layer is shallower (near vacuum) than the HOMO level of the host material, but the larger the difference therebetween, the higher the hole-trapping ability of the light-emitting layer. In addition, the LUMO level of the light-emitting material of the light-emitting layer is deeper (far from the vacuum level) than the LUMO level of the host material, but the larger the difference therebetween, the higher the electron-trapping ability of the light-emitting layer. Accordingly, the hole-trapping ability of the first light-emitting layer becomes lower than the electron-trapping ability of the second light-emitting layer by making the difference between the HOMO levels of the second light-emitting material and the first organic compound in the first light-emitting layer smaller than the difference between the LUMO levels of the third light-emitting material and second organic compound in the second light-emitting layer. That is, the recombination region recedes from the first electrode side of the first light-emitting layer by using the first electrode on the first light-emitting layer side as the positive electrode.

Here, HOMO means the highest occupied molecular orbital, and LUMO means the lowest unoccupied molecular orbital. The energy level of HOMO is also referred to as "HOMO" or "HOMO level", and the energy level of LUMO is also referred to as "LUMO" or "LUMO level".

The expressions [2] to [4] that are characteristics of the present invention show that the content of the light-emitting material in the first light-emitting layer is small. Specifically, as shown in expressions [2] and [3], the content of the first light-emitting material is smaller than those of the second light-emitting material and the third light-emitting material, and furthermore, as shown in expression [4], the content of the second light-emitting material is suppressed to be low, less than 2.0 mass%. Accordingly, the hole-trapping ability of the first light-emitting layer is suppressed to be lower than the electron-trapping ability of the second light-emitting layer, and the recombination region is located to be closer to the second light-emitting layer.

Furthermore, preferable conditions in the present invention will be described.

In the present invention, it is preferable to control the content of the third light-emitting material in the second light-emitting layer to 1.0 mass% or more, because the electron-trapping ability of the second light-emitting layer is increased, and the recombination region is located to be closer to the second light-emitting layer and can be kept away from the interface of the first light-emitting layer on the first electrode side.

The first light-emitting material preferably emits red light, and the content of the first light-emitting material in the first light-emitting layer is preferably less than 0.3 mass% and more preferably less than 0.2 mass%. A decrease in the content of the first light-emitting material is preferable because that the excitation loss due to concentration disappearance is suppressed and the light emission efficiency is improved. When the first light-emitting material emits red light, an organic light-emitting element that emits white light can be obtained by using one of the second light-emitting material and the third light-emitting material as the blue light-emitting material and the other as the green light-emitting material, but the present invention is not necessarily limited to such a configuration.

Regarding the thicknesses of the light-emitting layers, the thickness of the first light-emitting layer is preferably larger than that of the second light-emitting layer. This is also because, as described above, in order to locate the recombination region closer to the second light-emitting layer and delocalize the recombination region, a larger thickness of the first light-emitting layer by keeping the recombination region away from the interface of the first light-emitting layer on the first electrode side is effective.

The first organic compound and the second organic compound are preferably the same organic compounds. This is because that the absence of an energy barrier between the first light-emitting layer and the second light-emitting layer is preferable for delocalization of the recombination region.

The first light-emitting material, the second light-emitting material, and the third light-emitting material are not particularly limited as long as they each satisfy the energy relationship of the above expression [1], but the materials preferably have a fluoranthene skeleton. Since the fluoranthene skeleton is electron-deficient, the LUMO level is deep. Accordingly, such a material is suitable for the organic light-emitting element of the present invention. Examples of the light-emitting material according to the present invention are shown below, but are not limited thereto. R-1 to R-27 below are examples of the first light-emitting material, G-1 to G-24 are examples of the second light-emitting material, and B-1 to B-62 are examples of the third light-emitting material. In the present invention, the first light-emitting material is preferably a red light-emitting material, the second light-emitting material is preferably a green light-emitting material, and the third light-emitting material is preferably a blue light-emitting material.

[Chem. 1]

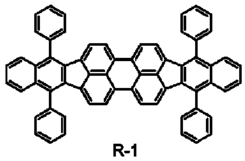
R-1
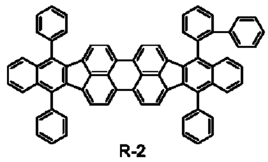
R-2
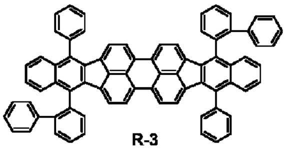
R-3
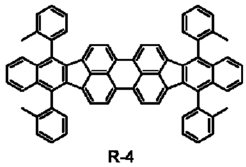
R-4
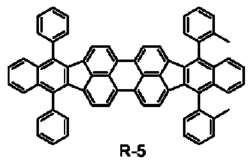
R-5
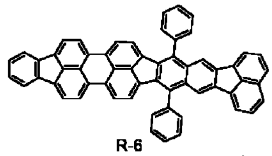
R-6
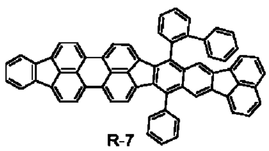
R-7
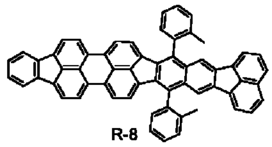
R-8
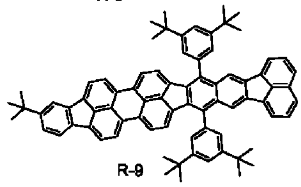
R-9
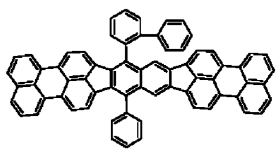
R-10
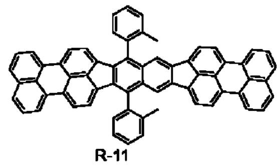
R-11
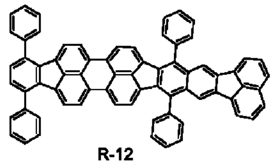
R-12
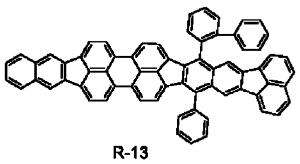
R-13
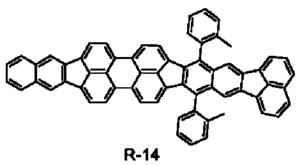
R-14
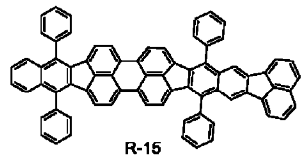
R-15
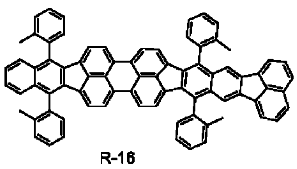
R-16
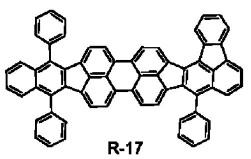
R-17
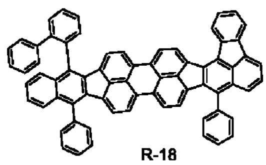
R-18
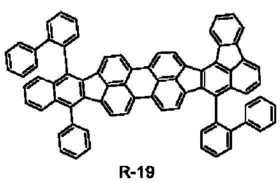
R-19
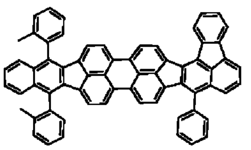
R-20
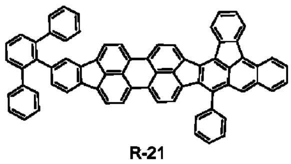
R-21
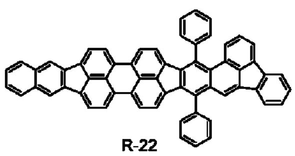
R-22
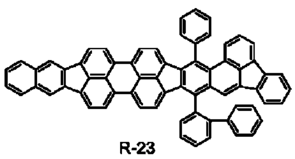
R-23
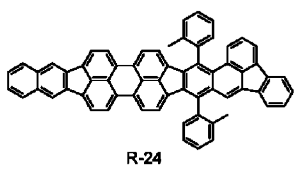
R-24
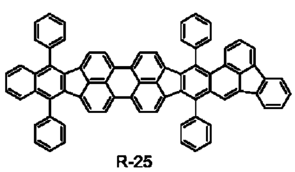
R-25
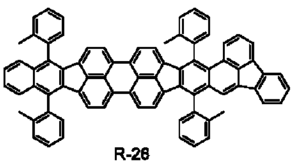
R-26
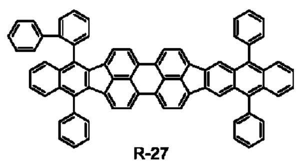
R-27

[Chem. 2]

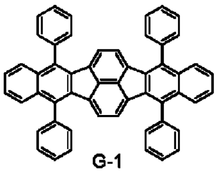
G-1
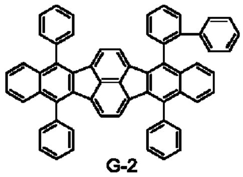
G-2
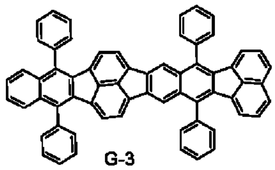
G-3
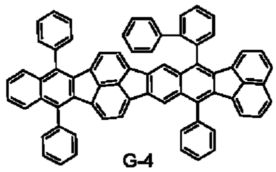
G-4
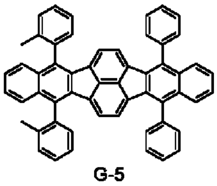
G-5
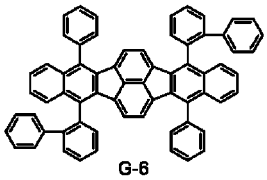
G-6
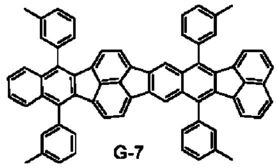
G-7
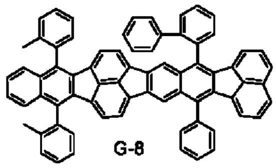
G-8
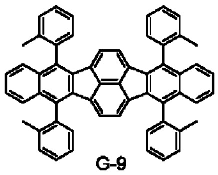
G-9
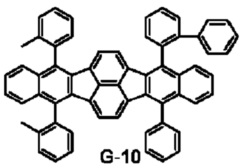
G-10
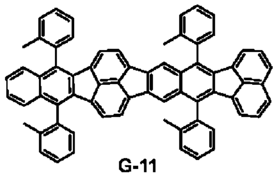
G-11
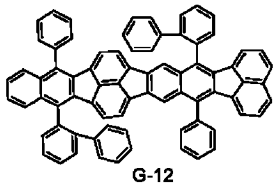
G-12
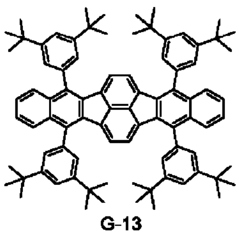
G-13
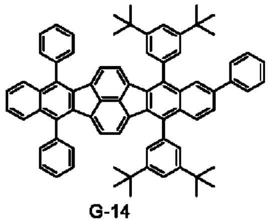
G-14
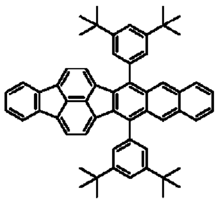
G-15
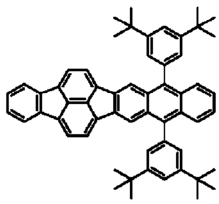
G-16
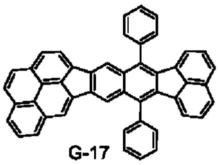
G-17
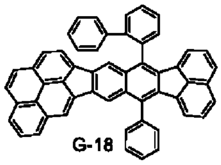
G-18
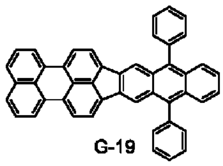
G-19
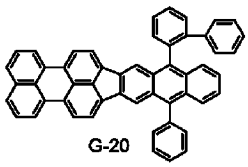
G-20
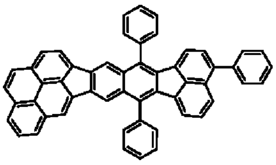
G-21
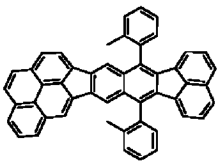
G-22
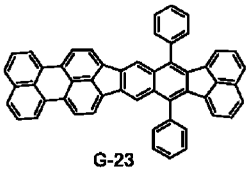
G-23
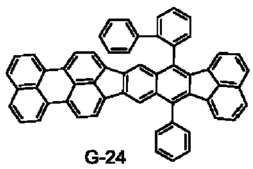
G-24

[Chem. 3]

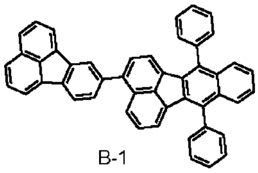
B-1
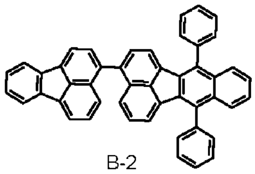
B-2
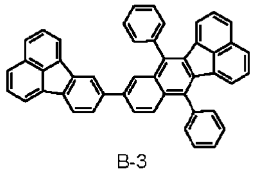
B-3

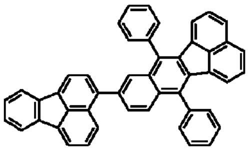
B-4
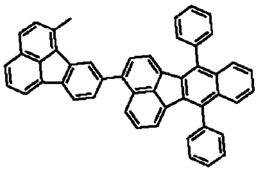
B-5
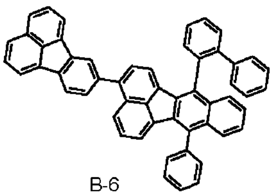
B-6

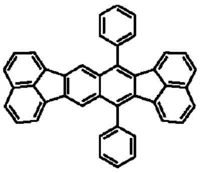
B-7
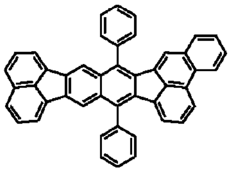
B-8
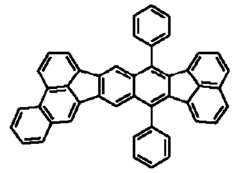
B-9

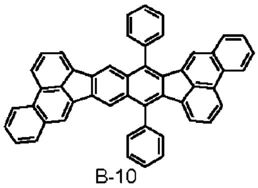
B-10
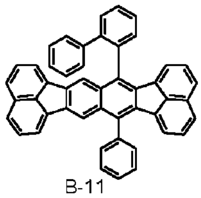
B-11
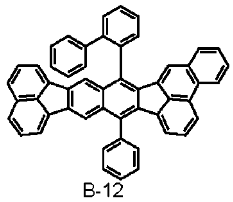
B-12

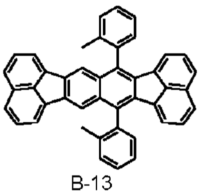
B-13
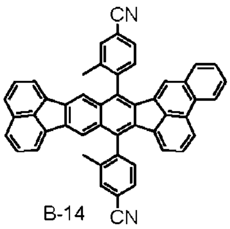
B-14
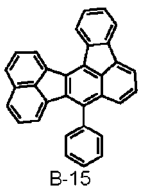
B-15
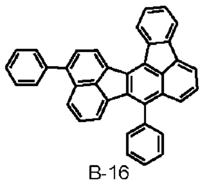
B-16

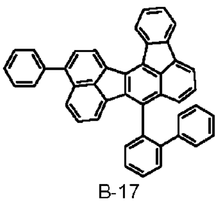
B-17
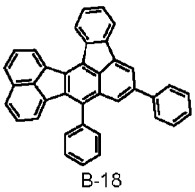
B-18
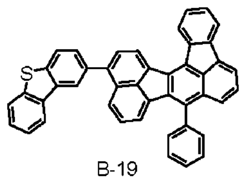
B-19

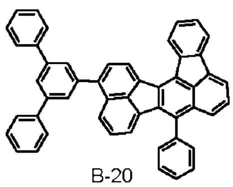
B-20
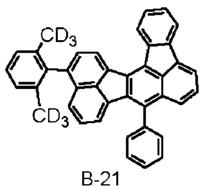
B-21
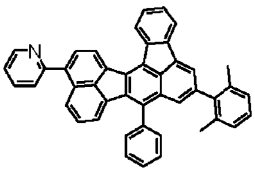
B-22

[Chem. 4]

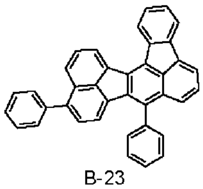
B-23

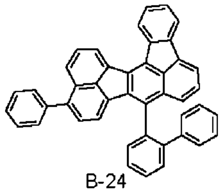
B-24

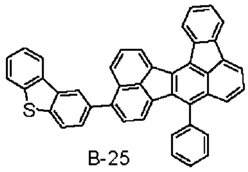
B-25

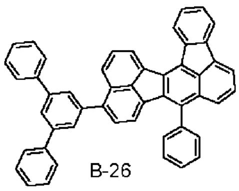
B-26

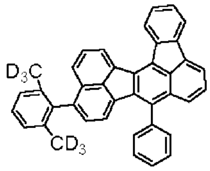
B-27

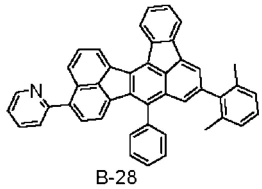
B-28

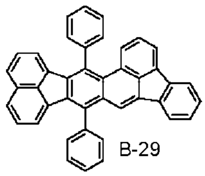
B-29

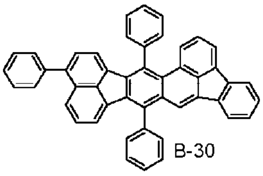
B-30

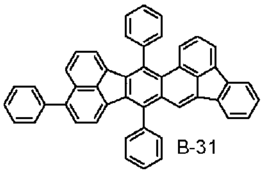
B-31

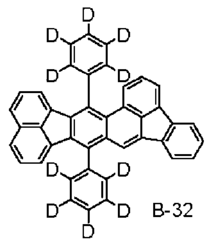
B-32

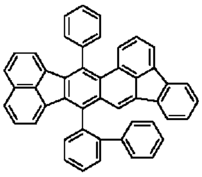
B-33

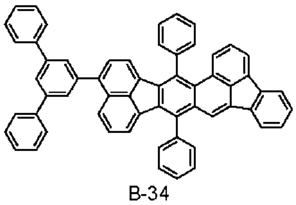
B-34

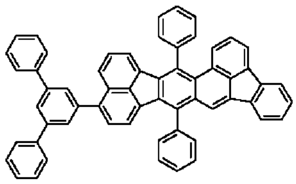
B-35

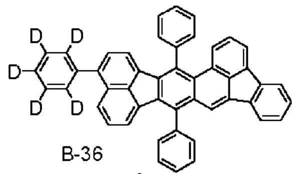
B-36

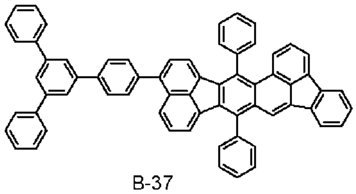
B-37

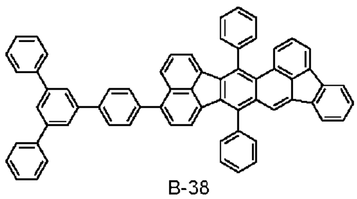
B-38

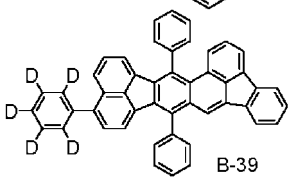
B-39

[Chem. 5]

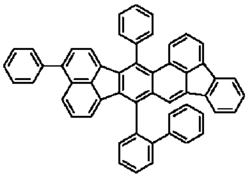
B-40

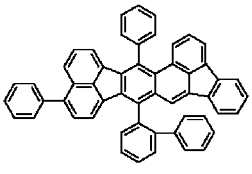
B-41

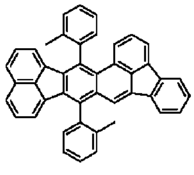
B-42

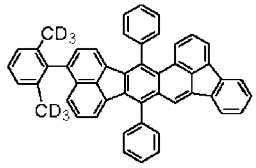
B-43

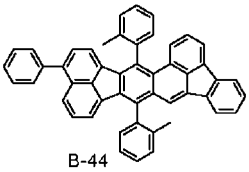
B-44

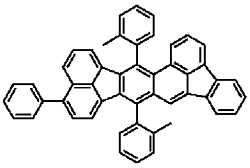
B-45

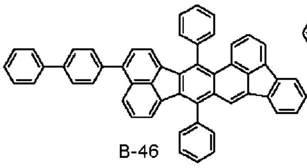
B-46

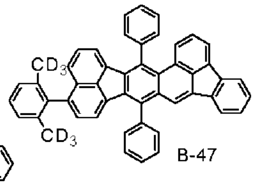
B-47

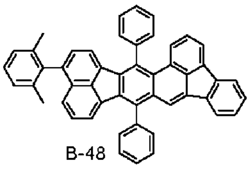
B-48

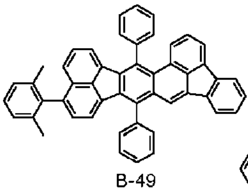
B-49

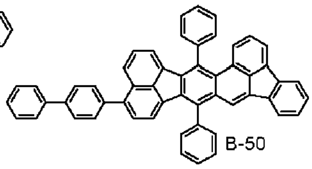
B-50

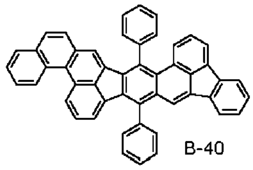
B-40

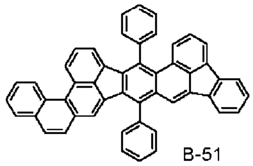
B-51

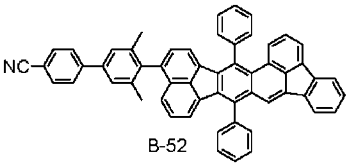
B-52

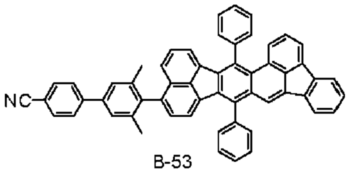
B-53

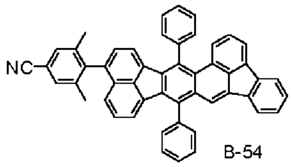
B-54

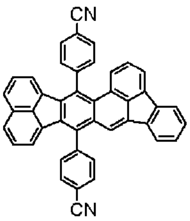
B-55

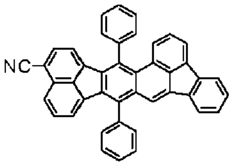
B-56

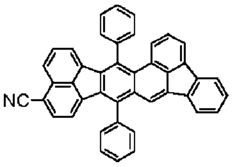
B-57

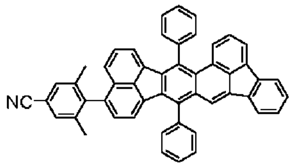
B-58

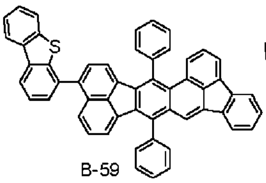
B-59

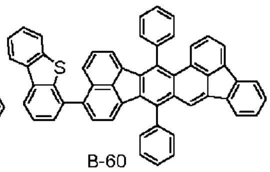
B-60

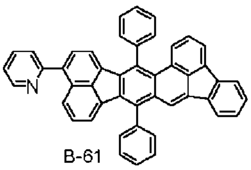
B-61

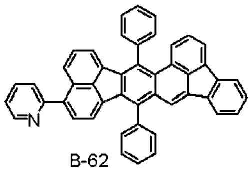
B-62

The first organic compound and the second organic compound are not particularly limited as long as they each satisfy the energy relationship of the above expression [1], but the materials preferably have a pyrene skeleton. The pyrene skeleton is preferable because it is highly planar and thereby advantageous for controlling charge transportation and also has an energy level that can be applied to all of blue light-emitting material, green light-emitting material, and red light-emitting material.

In both the first and second organic compounds, all of freely rotatable single bonds are preferably carbon-carbon bonds, and at least one carbon of the carbon-carbon bond is further preferably $sp^2$ carbon for a good durability characteristic.

The light-emitting layer generally includes a host material and a light-emitting dopant material. The first organic compound and second organic compound according to the present invention are host materials, and the first light-emitting material, second light-emitting material, and third light-emitting material are light-emitting dopant materials. The host material is a compound with the largest mass ratio among the compounds constituting the light-emitting layer. The light-emitting dopant is a compound with a mass ratio smaller than that of the host material among the compounds constituting

the light-emitting layer and is a main compound for light emission. The light-emitting layer may include an assist material in addition to the host material and the light-emitting dopant material. The assist material is a compound with a mass ratio that is smaller than that of the host material and larger than that of the light-emitting dopant material among the compounds constituting the light-emitting layer. That is, the mass ratios are (host material) > (assist material) > (light-emitting dopant material). The light-emitting dopant material is also referred to as a guest.

The contents of the first light-emitting material and second light-emitting material in the first light-emitting layer and the third light-emitting material in the second light-emitting layer according to the present invention may be any contents as long as they satisfy the above expressions [2] to [4].

The light-emitting material may be included uniformly or with a concentration gradient in the entire first light-emitting layer or second light-emitting layer in which the first organic compound or the second organic compound forms a matrix within a range in which the effects of the present invention can be obtained. The light-emitting layer may be a layer partially including a light-emitting material in a specific region of the layer so as to include a region where only a host is present without including the light-emitting material.

The first light-emitting layer, the second light-emitting layer, or a third light-emitting layer that is provided as needed according to the present invention can include a material other than the above-described first organic compound, second organic compound, first light-emitting material, second light-emitting material, and third light-emitting material within a range in which the effects of the present invention can be obtained.

Examples of the light-emitting material that is mainly related to the light-emitting function include, in addition to the above-mentioned light-emitting materials, a fused ring compound (e.g., a fluorene derivative, a naphthalene derivative, a pyrene derivative, a perylene derivative, a tetracene derivative, an anthracene derivative, and rubrene), a quinacridone derivative, a coumarin derivative, a stilbene derivative, an organoaluminum complex such as tris(8-quinolinolato) aluminum, an iridium complex, a platinum complex, a rhenium complex, a copper complex, a europium complex, a ruthenium complex, and a polymer derivative such as a poly(phenylenevinylene) derivative, a poly(fluorene) derivative, and a poly(phenylene) derivative. Examples of the compound that is used as the light-emitting material are specifically shown below, but are not limited thereto.

[Chem. 6]

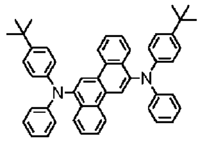
BD1
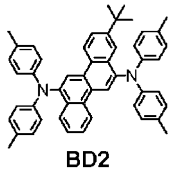
BD2
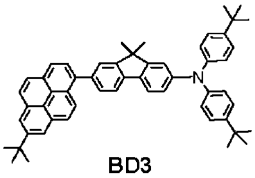
BD3
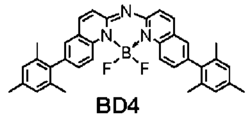
BD4

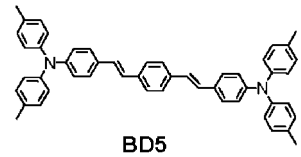
BD5
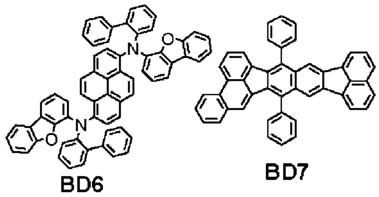
BD6 BD7
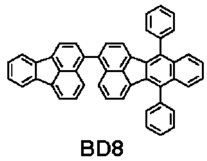
BD8

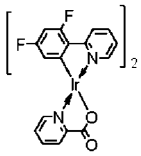
BD9
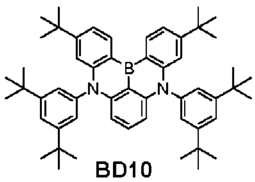
BD10

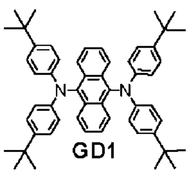
GD1
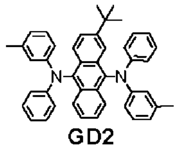
GD2
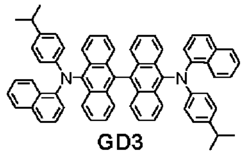
GD3
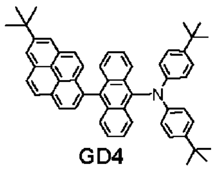
GD4

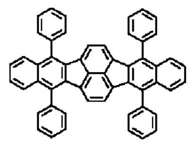
GD5
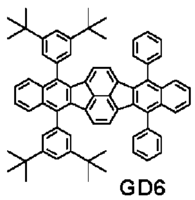
GD6
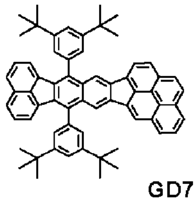
GD7
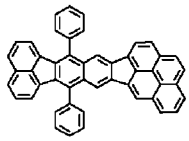
GD8

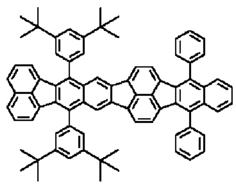
GD9
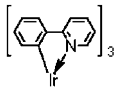
GD10
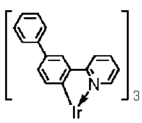
GD11
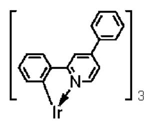
GD12
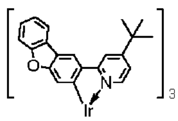
GD13

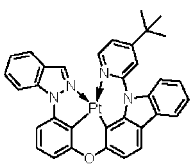
GD14
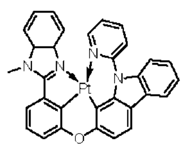
GD15
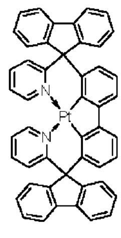
GD16
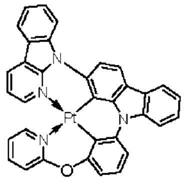
GD17
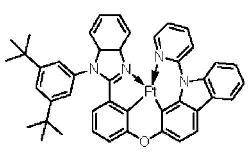
GD18

[Chem. 7]

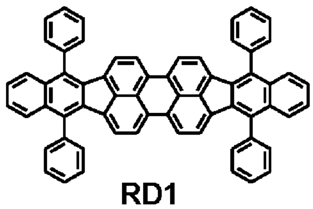

RD1

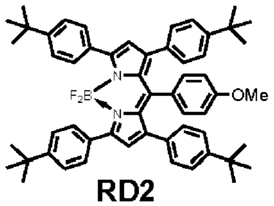

RD2

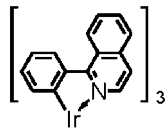

RD3

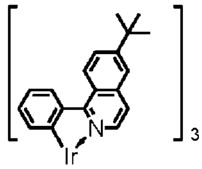

RD4

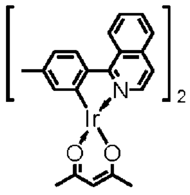

RD5

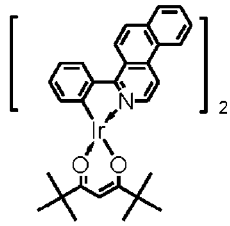

RD6

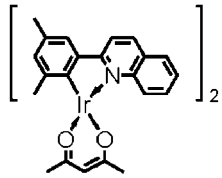

RD7

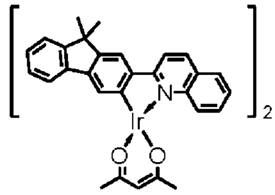

RD8

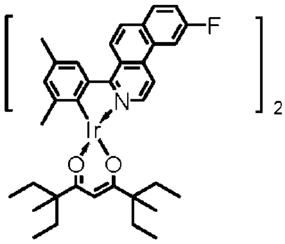

RD9

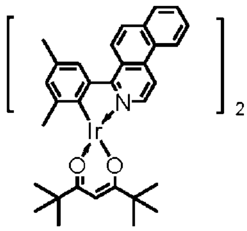

RD10

The first light-emitting layer and the second light-emitting layer may include a third organic compound other than the first organic compound and second organic compound as a host material or an assist material. Examples of the third organic compound include, in addition to aromatic hydrocarbon compounds and derivatives thereof, a carbazole derivative, an azine derivative, a xanthone derivative, a dibenzofuran derivative, a dibenzothiophene derivative, an organoaluminum complex such as tris(8-quinolinolato)aluminum, and an organoberyllium complex, but are not limited thereto. Examples are specifically shown below.

[Chem. 8]

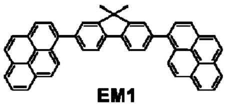
EM1
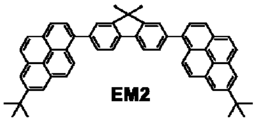
EM2
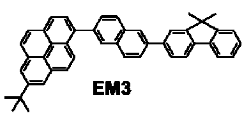
EM3
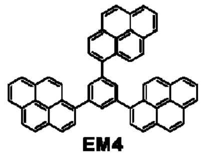
EM4
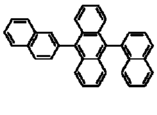
EM5
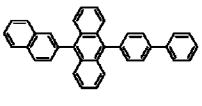
EM6
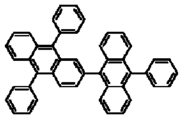
EM7
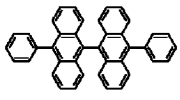
EM8
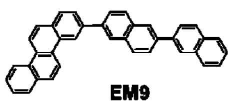
EM9
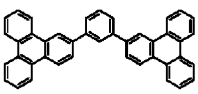
EM10
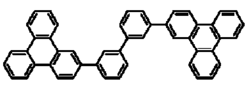
EM11
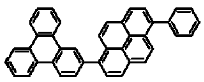
EM12
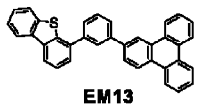
EM13
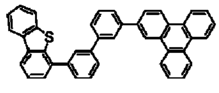
EM14
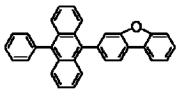
EM15
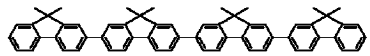
EM16
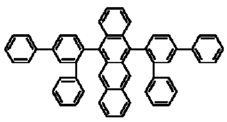
EM17
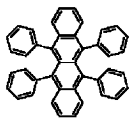
EM18
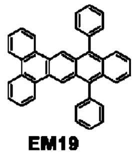
EM19
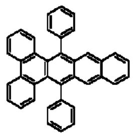
EM20
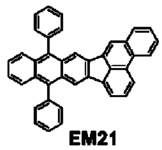
EM21
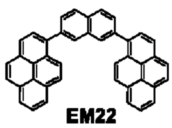
EM22
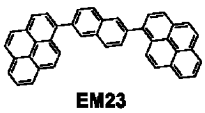
EM23
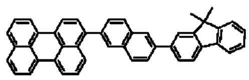
EM24
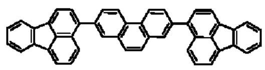
EM25
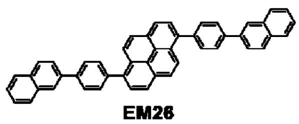
EM26
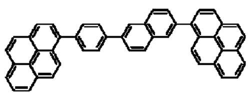
EM27
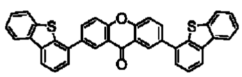
EM28
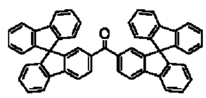
EM29
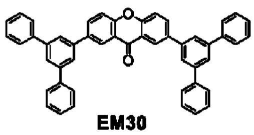
EM30
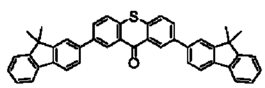
EM31
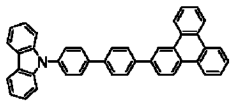
EM32
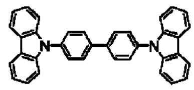
EM33
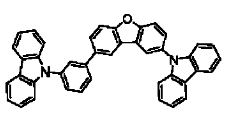
EM34
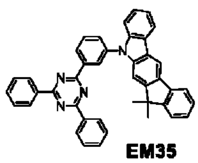
EM35
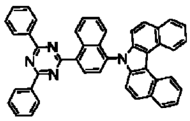
EM36
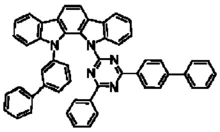
EM37
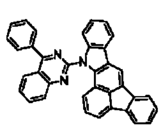
EM38
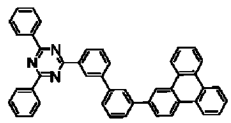
EM39
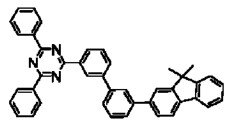
EM40

The organic light-emitting element of the present invention includes a first electrode, a second electrode, and an organic compound layer between the first electrode and the second electrode, and the organic compound layer at least includes a first light-emitting layer and a second light-emitting layer. In the present invention, a functional layer may be appropriately disposed between the first electrode and the first light-emitting layer and between the second light-emitting layer and the second electrode. Examples of the functional layer include, in addition to the light-emitting layer, a hole injection layer, a hole transport layer, an electron-blocking layer, a hole/exciton-blocking layer, an electron transport layer, and an electron injection layer. In addition, a light-emitting layer other than the first light-emitting layer and second light-emitting layer according to the present invention may be provided.

In the present invention, an adjacent layer that is adjacent to the second light-emitting layer on the negative electrode may be disposed, and the adjacent layer is preferably made of an organic compound composed of hydrocarbon. The reason thereof will be described.

As described above, it is characteristic that the recombination region of the organic light-emitting layer of the present invention is closer to the second light-emitting layer side. Accordingly, the adjacent layer that is adjacent to the second light-emitting layer is located in a region where large numbers of charges and excitons are present, and deterioration of the organic compound easily occurs. Accordingly, the adjacent layer according to the present invention is preferably made of an organic compound composed of hydrocarbon having high binding stability and chemical stability. Examples thereof include compounds such as the above-mentioned EM1 to EM12 and EM16 to EM27, but are not limited thereto as long as the compound is constituted of hydrocarbon.

The organic compound composed of hydrocarbon preferably has a fused-polycyclic skeleton with four or more rings. This provides the following effects due to its large number of fused rings. The first one is that the band gap is reduced to decrease the voltage in the organic light-emitting element. The second one is that the thermal stability, such as the glass transition temperature, is improved. The third one is that the planarity is increased, and thereby the electron mobility is improved to decrease the voltage in the organic light-emitting element.

The organic compound composed of hydrocarbon is preferably entirely composed of $sp^2$ carbon. This is because that the binding energy between $sp^2$ carbon atoms is higher than that between $sp^3$ carbon atoms and therefore a molecular structure with higher binding stability is obtained.

The second organic light-emitting element of the present invention includes a first electrode, a first light-emitting layer, a second light-emitting layer, an adjacent layer, and a second electrode in this order, wherein the first light-emitting layer includes a first organic compound, a first light-emitting material, and a second light-emitting material, the second light-emitting layer includes a second organic compound and a third light-emitting material, the adjacent layer is made of an organic compound composed of hydrocarbon, and the following expression [4] is satisfied:

the content of the second light-emitting material < 2.0 mass%. [4]

The present inventors found that it is preferable that the content of the second light-emitting material in the organic light-emitting element of the present invention is less than 2.0 mass%. This is due to the following two reasons. The first one is that since concentration quenching occurs when the content of the second light-emitting material of the present invention is 2.0 mass% or more, a content of less than 2.0 mass% is preferable for a high efficiency. Further preferably, the second light-emitting material is an organic compound constituted of hydrocarbon. When the compound is constituted of hydrocarbon only, the planarity is increased, and the concentration quenching becomes more significant. The second one is that the hole-trapping ability of the first light-emitting layer is suppressed by keeping the content of the second light-emitting material to less than 2.0 mass%, and the recombination region is located to be closer to the second light-emitting layer. As a result, the recombination region reaches to the interface between the second light-emitting layer and the adjacent layer. Accordingly, the structural stability of the adjacent layer affects the characteristics. That is, the organic compound constituting the adjacent layer is preferably made of hydrocarbon with high binding stability.

A light-emitting layer configuration that can achieve both a high efficiency and a high durability characteristic by the above two factors was found.

A charge-generating layer may be disposed between the first light-emitting layer and the first electrode and between the second light-emitting layer and the second electrode. The charge-generating layer expresses the function as a tandem element, charge recombination of electrons generated from the charge-generating layer and holes injected from the first electrode generates excitons, and charge recombination of holes generated from charge-generating layer and electrons injected from the second electrode forms excitons. Consequently, the internal quantum efficiency is doubled. Film formation is also performed by deposition or coating.

Examples of the element configuration of the organic light-emitting element of the present embodiment include multilayer element configurations in which electrode layers and organic compound layers shown by (1) to (6) below are stacked sequentially on a substrate. In every element configuration, the organic compound layer necessarily includes a light-emitting layer containing a light-emitting material. The "light-emitting layer" below includes a first light-emitting layer and a second light-emitting layer according to the present invention such that the first light-emitting layer is on the positive electrode side and the second light-emitting layer is on the negative electrode side.

(1) positive electrode/light-emitting layer/negative electrode;
(2) positive electrode/hole transport layer/light-emitting layer/electron transport layer/negative electrode;
(3) positive electrode/hole transport layer/light-emitting layer/electron transport layer/electron injection layer/negative electrode;

(4) positive electrode/hole injection layer/hole transport layer/light-emitting layer/electron transport layer/negative electrode;

(5) positive electrode/hole injection layer/hole transport layer/light-emitting layer/electron transport layer/electron injection layer/negative electrode; and

(6) positive electrode/hole transport layer/electron-blocking layer/light-emitting layer/hole-blocking layer/electron transport layer/negative electrode.

However, these element configuration examples are merely basic element configurations and are not limited thereto. For example, it is possible to adopt various layer configurations such as a configuration in which an insulating layer, an adhesion layer, or an interference layer is disposed at the interface between the electrode and the organic compound layer or a configuration in which the electron transport layer or the hole transport layer is composed of two layers having different ionization potentials.

In the element configurations shown by the above (1) to (6), the configuration of (6) is preferable because it is a configuration including both an electron-blocking layer and a hole-blocking layer. That is, in (6) including an electron-blocking layer and a hole-blocking layer, since both hole and electron carriers can be certainly confined in the light-emitting layer, an organic light-emitting element with high light emission efficiency without causing carrier leakage is obtained.

The compounds of the electron-blocking layer and the hole-blocking layer that are in contact with the light-emitting layer preferably have stable structures. For example, since the hole-blocking layer is required to be stable against holes, the hole-blocking layer compound is preferably an organic compound with low reactivity and further preferably an organic compound composed of hydrocarbon only. Since the electron-blocking layer also is required to be stable against electrons, an organic compound with low reactivity is preferable, and an organic compound of which all the carbon-carbon bonds are freely rotatable single bonds, preferably $sp^2$ carbon-$sp^2$ carbon bonds, is further preferable.

The mode (element form) for extracting light that is emitted from the light-emitting layer may be a so-called bottom emission system in which light is extracted from the electrode on the substrate side or may be a so-called top emission system in which light is extracted from the other side of the substrate. Alternatively, a both-side emission system in which light is extracted from the substrate side and the other side of the substrate can also be adopted.

The organic compound layer is mainly constituted of an organic compound, but may include an inorganic atom or an inorganic compound, such as copper, lithium, magnesium, aluminum, iridium, platinum, molybdenum, and zinc.

The organic compound layer can be formed using a dry process such as a vacuum deposition method, an ionization deposition method, sputtering, and a plasma method. Instead of the dry process, a wet process that forms a layer by a known application using an appropriate solvent for dissolution (e.g., spin coating, dipping, a cast method, an LB method, and an ink jet method) can also be used.

Here, when a layer is formed by a vacuum deposition method or a solution application method, crystallization hardly occurs, and stability over time is excellent. When a layer is formed by an application method, a film can also be formed by combination with an appropriate binder resin.

Examples of the binder resin include, but not limited to, a polyvinylcarbazole resin, a polycarbonate resin, a polyester resin, an ABS resin, an acrylic resin, a polyimide resin, a phenol resin, an epoxy resin, a silicone resin, and a urea resin.

These binder resins may be used alone as a homopolymer or a copolymer or may be used as a mixture of two or more. Furthermore, as needed, known additives, such as a plasticizer, an antioxidant, and an UV absorber, may be used in combination.

In the present invention, in a layer other than the light-emitting layer, known low- and high-molecular-weight hole-injection compounds or hole-transport compounds, an electron injection compound or electron transport compound, and so on can be used as needed. Examples thereof are specifically mentioned below.

The hole injecting/transporting material is preferably a material that facilitates injection of holes from the positive electrode and has high hole mobility so as to transport the injected holes to the light-emitting layer. In addition, a material having a high glass transition temperature is preferable in order to suppress the deterioration of the film quality, such as crystallization, in the organic light-emitting element. Examples of the low- and high-molecular-weight materials having hole injecting/transporting ability include a triarylamine derivative, an arylcarbazole derivative, a phenylenediamine derivative, a stilbene derivative, a phthalocyanine derivative, a porphyrin derivative, poly(vinylcarbazole), poly(thiophene), and other conductive polymers. Furthermore, the hole injecting/transporting material is also suitably used in the electron-blocking layer. Examples of the compound that is used as the hole injecting/transporting material are specifically shown below, but are not limited thereto.

[Chem. 9]

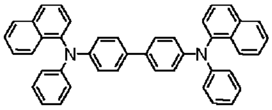

HT1

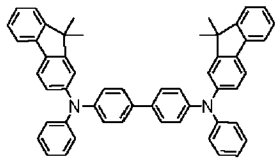

HT2

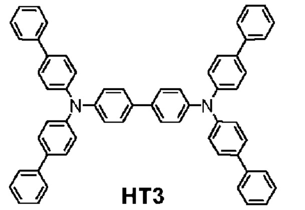

HT3

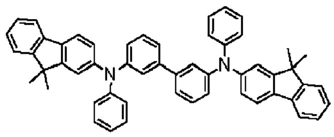

HT4

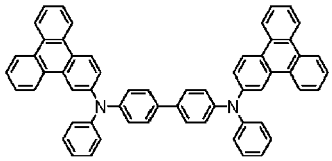

HT5

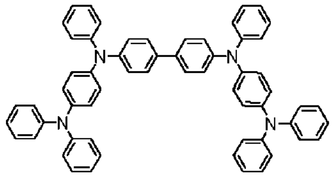

HT6

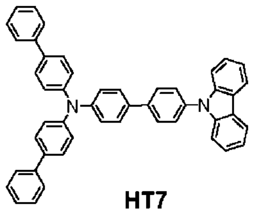

HT7

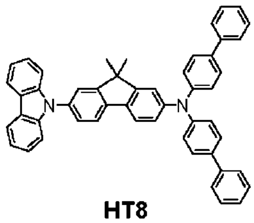

HT8

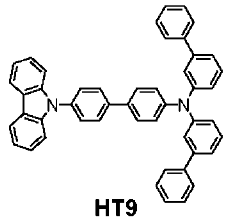

HT9

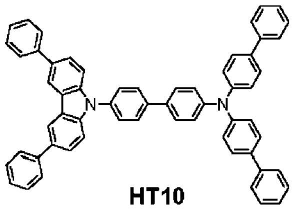

HT10

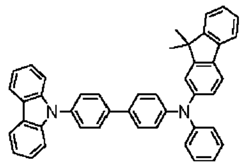

HT11

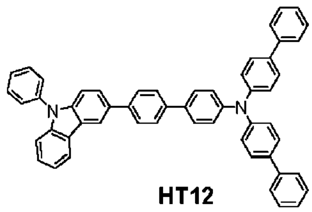

HT12

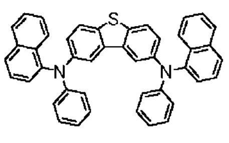

HT13

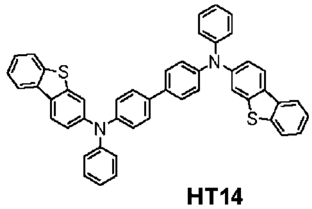

HT14

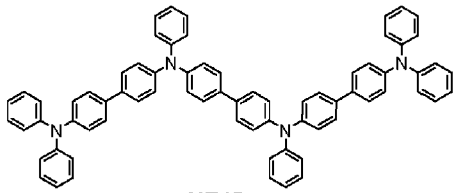

HT15

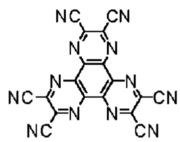

HT16

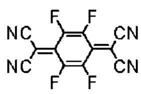

HT17

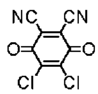

HT18

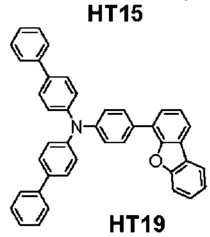

HT19

The electron transporting material can be arbitrarily selected from materials that can transport electrons injected from a negative electrode to a light-emitting layer and is selected considering, for example, the balance with the hole mobility of a hole transporting material. Examples of the material having electron transporting ability include an oxadiazole derivative, an oxazole derivative, a pyrazine derivative, a triazole derivative, a triazine derivative, a quinoline derivative, a quinoxaline derivative, a phenanthroline derivative, an organoaluminum complex, a fused ring compound (e.g., a fluorene derivative, a naphthalene derivative, a chrysene derivative, and an anthracene derivative). Furthermore, the above-mentioned electron transporting materials are also suitably used in the hole-blocking layer. Examples of the compound that is used as the electron transporting material are specifically shown below, but are not limited thereto. The examples are as follows.

[Chem. 10]

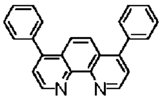
ET1
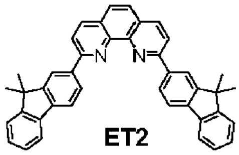
ET2
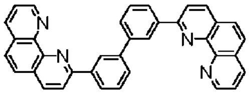
ET3
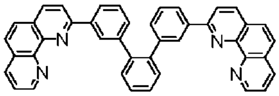
ET4

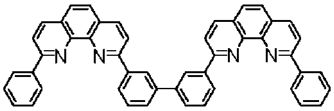
ET5
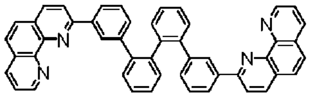
ET6
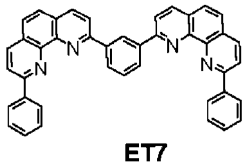
ET7

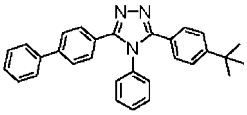
ET8
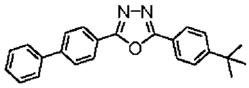
ET9
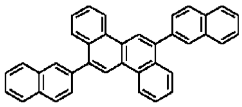
ET10
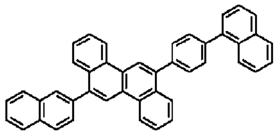
ET11

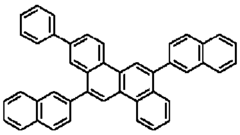
ET12
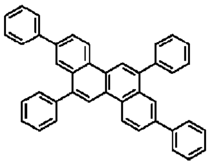
ET13
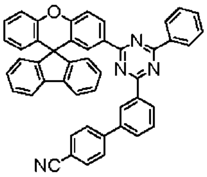
ET14
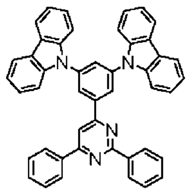
ET15

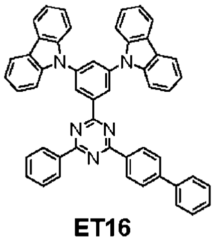
ET16
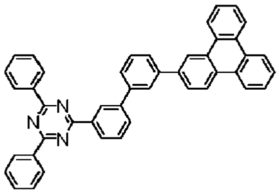
ET17
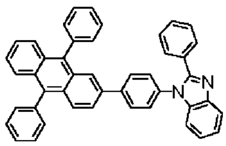
ET18
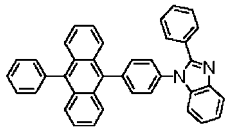
ET19

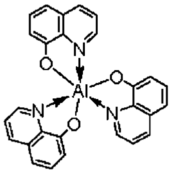
ET20
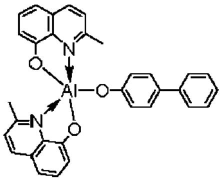
ET21
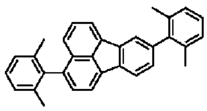
ET22
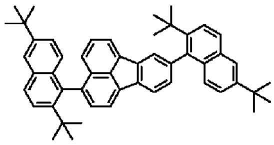
ET23

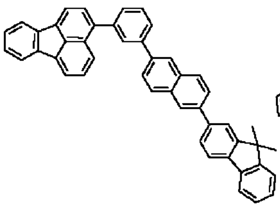
ET24
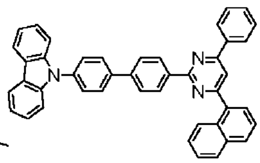
ET25
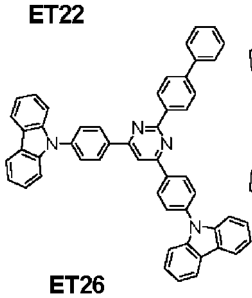
ET26
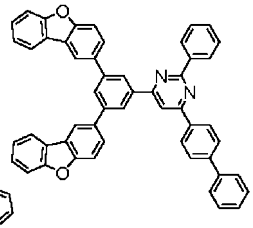
ET27

The electron injecting material can be arbitrarily selected from materials that can easily perform injection of electrons from a negative electrode and is selected considering, for example, the balance with the hole injection property. As the organic compound, an n-type dopant and a reducing dopant are also included, and examples thereof include a compound containing an alkali metal, such as lithium fluoride, a lithium complex such as lithium quinolinol, a benzimidazolidene derivative, an imidazolidene derivative, a fulvalene derivative, and an acridine derivative. It is also possible to use in combination with the above-mentioned electron-transporting material.

[Other configuration of organic light-emitting element]

The organic light-emitting element is generally provided by forming an insulating layer, a first electrode, an organic compound layer, and a second electrode on a substrate. On the second electrode, a protective layer, a color filter, a microlens, or the like may be provided. When a color filter is provided, a planarizing layer may be disposed between the color filter and the protective layer. The planarizing layer can be made of an acryl resin or the like. The same is applied to when a planarizing layer is disposed between a color filter and a microlens.

Preferable configurations of the organic light-emitting element of the present invention excluding the organic compound layer will be described below.

[Substrate]

The organic light-emitting element of the present invention may be formed on a substrate. Examples of the substrate include quartz, glass, a silicon wafer, a resin, and a metal. On the substrate, a switching element such as a transistor and wiring are provided, and an insulating layer may be provided thereon. The insulating layer may be made of any material that can be formed with a contact hole so that wiring with the first electrode can be formed and can guarantee insulation from unconnected wiring. For example, a resin such as polyimide, silicon oxide, or silicon nitride can be used.

[Electrode]

In the present invention, one of the first electrode and the second electrode is a positive electrode, and the other is a negative electrode. When an electric field is applied in the direction in which the organic light-emitting element emits light, the electrode with a higher potential is the positive electrode, and the electrode with a lower potential is the negative electrode. Alternatively, an electrode that supplies holes to the light-emitting layer is the positive electrode, and the electrode that supplies electrons is the negative electrode.

The positive electrode is preferably made of a material that has as large a work function as possible. For example, it is possible to use an elemental metal such as gold, platinum, silver, copper, nickel, palladium, cobalt, selenium, vanadium, and tungsten, a mixture containing them, or an alloy of a combination thereof, or a metal oxide such as tin oxide, zinc oxide, indium oxide, indium tin oxide (ITO), and indium zinc oxide. A conductive polymer, such as polyaniline, polypyrrole, or polythiophene, also can be used.

These electrode materials may be used alone or in combination of two or more. The positive electrode may be constituted of one layer or may be constituted of a plurality of layers.

In the use as a reflection electrode, for example, chromium, aluminum, silver, titanium, tungsten, molybdenum, or an alloy or stack thereof can be used. The above-mentioned material can also function as a reflection film not having a role as an electrode. In the use as a transparent electrode, a transparent conductive layer of an oxide such as indium tin oxide (ITO) and indium zinc oxide can be used, but the layer is not limited thereto. The electrode can be formed using photolithography.

In contrast, the negative electrode is preferably made of a material having a small work function. Examples thereof include an alkali metal such as lithium, an alkaline earth metal such as calcium, an elemental metal such as aluminum, titanium, manganese, silver, lead, and chromium, and mixtures including them. Alternatively, an alloy of a combination of these elemental metals can also be used. For example, magnesium-silver, aluminum-lithium, aluminum-magnesium, silver-copper, and zinc-silver can be used. A metal oxide such as indium tin oxide (ITO) can also be used. These electrode materials may be used alone or in combination of two or more. The negative electrode may be constituted of one layer or may be constituted of a plurality of layers. In particular, it is preferable to use silver, and a silver alloy is further preferable for reducing aggregation of silver. The alloy ratio is not important as long as the aggregation of silver can be reduced. For example, the ratio of silver : another metal may be 1 : 1, 3 : 1, or the like.

The negative electrode is not particularly limited, and an oxide conductive layer of ITO or the like may be used to form a top emission element, or a reflection electrode of aluminum (Al) or the like may be used to from a bottom emission element. The method for forming the negative electrode is not particularly limited, but DC and AC sputtering is preferable because of its high film coverage and the ease in reduction of resistance.

[Protective layer]

A protective layer may be disposed on the second electrode. For example, infiltration of water or the like into the organic compound layer is reduced by adhering glass provided with a moisture absorbent onto the second electrode, and thereby occurrence of a display defect can be reduced. In another embodiment, the infiltration of water or the like into the organic compound layer may be reduced by providing a passivation film of silicon nitride or the like on the second electrode. For example, the second electrode is formed and is then transferred to another chamber without breaking the

vacuum, and a silicon nitride film with a thickness of 2 μm may be formed by a CVD method as a protective layer. After film formation by the CVD method, a protective layer may be formed using an atomic layer deposition method (ALD method). The material of the film by the ALD method is not limited, but may be silicon nitride, silicon oxide, aluminum oxide, or the like. On the film formed by the ALD method, a silicon nitride film may be further formed by the CVD method. The film by the ALD method may have a thickness smaller than that of the film formed by the CVD method. Specifically, the thickness by the ALD method may be 50% or less or 10% or less of the thickness by the CVD method.

[Color filter]

A color filter may be disposed on the protective layer. For example, a color filter is disposed on another substrate, considering the size of the organic light-emitting element, and this substrate and a substrate provided with an organic light-emitting element may be pasted together, or a color filter may be patterned on the above-described protective layer using a photolithography technique. The color filter may be made of a polymer.

[Planarizing layer]

A planarizing layer may be disposed between the color filter and the protective layer. The planarizing layer is provided for the purpose of reducing the unevenness in the lower layer. The planarizing layer may also be called a material resin layer without any restriction on the purpose. The planarizing layer may be made of an organic compound, which may be a low molecular weight or high molecular weight compound and is preferably a polymer.

The planarizing layer may be disposed above and below the color filter, and the constituent materials thereof may be the same or different. Examples of the material include a polyvinylcarbazole resin, a polycarbonate resin, a polyester resin, an ABS resin, an acrylic resin, a polyimide resin, a phenol resin, an epoxy resin, a silicone resin, and a urea resin.

[Microlens]

An organic light-emitting element or a light emission device including the organic light-emitting element may include an optical member, such as a microlens, on the light emission side. The microlens can be made of an acrylic resin, an epoxy resin, or the like. The purpose of the microlens may be an increase in the amount of light to be extracted from the organic light-emitting element or the light emission device or control of the direction of light to be extracted. The microlens may have a hemispherical shape. When the microlens has a hemispherical shape, the tangential lines that are in contact with the hemisphere include a tangential line that is parallel to the insulating layer, and the contact point of the tangent line with the hemisphere is the vertex of the microlens. The vertex of the microlens can be determined similarly also in an arbitrary cross-sectional diagram. That is, the tangential lines that are in contact with the microlens hemisphere in a cross-sectional diagram include a tangential line that is parallel to the insulating layer, and the contact point of the tangent line with the hemisphere is the vertex of the microlens.

The middle point of the microlens can also be defined. In a cross-section of the microlens, a line segment from the point where the shape of an arc ends to the point where the shape of another arc ends is imagined, and the middle point of the line segment can be called the middle point of the microlens. The cross-section to determine the vertex or the middle point may be a cross-section vertical to the insulating layer.

[Counter substrate]

A counter substrate may be disposed on the planarizing layer. Since the counter substrate is disposed at a position corresponding to the above-described substrate, it is called a counter substrate. The constituent material of the counter substrate may be the same as that of the above-described substrate. The counter substrate is a second substrate when the above-described substrate is called a first substrate.

[Pixel circuit]

The light emission device including the organic light-emitting element may include a pixel circuit that is connected to the organic light-emitting element. The pixel circuit may be an active matrix type that controls light emission of each of a plurality of organic light-emitting elements independently. The active matrix type circuit may be a voltage programming circuit or a current programming circuit. The driving circuit includes a pixel circuit for each pixel. The pixel circuit may include a transistor for controlling the organic light-emitting element and the light emission luminance of the organic light-emitting element, a transistor for controlling the light emission timing, and a transistor for connecting a capacitor for holding the gate voltage of the transistor that controls light emission luminance to GND without intervention of the light-emitting element.

The light emission device includes a display region and a peripheral region arranged around the display region. The display region includes a pixel circuit, and the peripheral region includes a display controlling circuit. The mobility of the transistor constituting the pixel circuit may be smaller than the mobility of the transistor constituting the display controlling circuit. The slope of current-voltage characteristic of the transistor constituting the pixel circuit may be smaller than the slope of current-voltage characteristic of the transistor constituting the display-controlling circuit. The slope of a current-voltage characteristic can be measured by the so-called Vg-Ig characteristic. The transistor constituting a pixel circuit is the transistor that is connected to the organic light-emitting element.

[Pixel]

The light emission device including the organic light-emitting element may include a plurality of pixels. The pixels each include sub-pixels that emit light of different colors from each other. The sub-pixels may have, for example, RGB emission light colors, respectively.
The pixel emits light from a region that is also called a pixel opening. The pixel opening may be 15 μm or less and may be 5 μm or more and, more specifically, may be, for example, 11 μm, 9.5 μm, 7.4 μm, or 6.4 μm. The distance between sub-pixels may be 10 μm or less, specifically, 8 μm, 7.4 μm, or 6.4 um.
The pixels may take a known arrangement in a planar view, such as a stripe arrangement, a delta arrangement, a pentile arrangement, or a Bayer arrangement. The shape of the sub-pixel in a planar view may be any known shape, for example, a quadrangle, such as a rectangle and a rhombus, or a hexagon. If the shape is not exact, but is close to a rectangle, it is of course included in the rectangle. The shape of the sub-pixel and the pixel arrangement can be used in combination.

[Application of organic light-emitting element]

The organic light-emitting element of the present invention can be used as a component of a display apparatus or an illuminating apparatus. In addition, there are applications such as the exposure light source of an electrophotographic image formation apparatus, the backlight of a liquid crystal display apparatus, and a light emission device including color filters in the white light source.
The display apparatus may be an image information processing apparatus that includes an image input unit for inputting image information from an area CCD, a linear CCD, a memory card, or the like, includes an information processing unit for processing the input information, and displays the input image on the display unit. The display apparatus includes a plurality of pixels of which at least one includes the organic light-emitting element of the present invention and may further include a transistor that is connected to the organic light-emitting element.
The display unit of an image pickup apparatus or inkjet printer may have a touch panel function. The driving system of this touch panel function may be an infrared system, an electrostatic capacity system, a resistive film system, or an electromagnetic induction system, and is not particularly limited. The display apparatus may be used in the display unit of a multi-functional printer.
Subsequently, a display apparatus according to the present embodiment will be described with reference to drawings.
Figs. 1A and 1B are schematic cross-sectional views illustrating examples of a display apparatus including an organic light-emitting element of the present invention and a transistor connected to this organic light-emitting element.
Fig. 1A shows an example of the pixel that is a component of the display apparatus according to the present embodiment. The pixel includes sub-pixels 20. The sub-pixels are divided into 20R, 20G, and 20B depending on the emission light. The emission light colors may be distinguished by the wavelengths of light emitted from the light-emitting layer, or selective penetration or color conversion of the light emitted from sub-pixels may be performed by a color filter or the like. Each sub-pixel includes a first electrode 12, which is a reflection electrode, on an interlayer insulating layer 11, an insulating layer 13 covering the edge of the first electrode 12, an organic compound layer 14 covering the first electrode 12 and the insulating layer 13, a second electrode 15, a protective layer 16, and a color filter 17. The first electrode 12, the organic compound layer 14, and the second electrode 15 constitute the organic light-emitting element 18 of the present embodiment.
A transistor or a capacitive element may be disposed underneath or inside the interlayer insulating layer 11. The transistor and the first electrode 12 may be electrically connected to each other via a contact hole (not shown).
The insulating layer 13 is also called a bank or a pixel separation film. The insulating layer 13 covers the end of the first electrode 12 and is disposed so as to surround the first electrode 12. A portion of the first electrode 12 where the insulating layer 13 is not provided is in contact with the organic compound layer 14 and becomes a light emission region.
The second electrode 15 may be a transparent electrode, a reflection electrode, or a semitransparent electrode.
The protective layer 16 reduces penetration of moisture into the organic compound layer 14. The protective layer 16 is illustrated as a single layer but may be a multi-layer. The multi-layer may include an inorganic compound layer and an

organic compound layer.

The color filter 17 is divided into 17R, 17G, and 17B depending on its color. The color filter may be formed on a planarizing film (not shown). In addition, a resin protective layer (not shown) may be provided on the color filter. The color filter 17 may be formed on the protective layer 16 or may be disposed on a counter substrate such as a glass substrate and then pasted.

The display apparatus of Fig. 1B includes an organic light-emitting element 36 and a TFT 28 as an example of a transistor. Specifically, an insulating layer 22 is disposed on a substrate 21 of glass, silicon, or the like, and on the insulating layer 22, the TFT 28 including a gate electrode 23, a gate insulating film 24, a semiconductor layer 25, a drain electrode 26, and a source electrode 27 is arranged. An insulating film 29 is disposed on the TFT 28, and a positive electrode 31 constituting the organic light-emitting element 36 and the source electrode 27 are connected to each other through a contact hole 30 provided in the insulating film 29.

The system for electrical connection of the electrodes (the positive electrode 31 and the negative electrode 33) included in the organic light-emitting element 36 and the electrodes (the source electrode 27 and the drain electrode 26) included in the TFT 28 is not limited to the mode shown in Fig. 1B. That is, it is sufficient that one of the positive electrode 31 and the negative electrode 33 and one of the source electrode 27 and the drain electrode 26 are electrically connected to each other. The TFT 28 refers to a thin-film transistor.

On the negative electrode 33, a first protective layer 34 and a second protective layer 35 for reducing deterioration of the organic light-emitting element are provided.

In the organic light-emitting element 36 according to the present embodiment, the light emission luminance is controlled by the TFT 28, and an image can be displayed by light emission luminance of each of a plurality of organic light-emitting elements 36 provided in a plane.

The display apparatus of Fig. 1B uses a transistor as a switching element, but instead of this, another switching element may be used.

The transistor that is used in the display apparatus of Fig. 1B is not limited to a TFT including an active layer on the insulative surface of the substrate and may be a transistor using a single-crystal silicon wafer. The active layer may be a non-single-crystal silicon such as amorphous silicon and microcrystal silicon or a non-single-crystal oxide semiconductor such as an indium zinc oxide and an indium gallium zinc oxide.

A transistor formed of low temperature polysilicon or an active matrix driver formed on a substrate such as a Si substrate may be used. "On a substrate" can also be said to "inside the substrate. Whether a transistor is provided in a substrate or a TFT is used is selected based on the size of the display unit. For example, when the display unit has a size of about 0.5 inches, it is preferable to dispose an organic light-emitting element on a Si substrate. Here, formation inside a substrate means that a transistor is produced by processing the substrate itself, such as a Si substrate. That is, having a transistor within a substrate can also be regarded as the substrate and the transistor being integrally formed.

Fig. 2 is a schematic view illustrates an example of the display apparatus according to the present invention. The display apparatus 1000 includes a touch panel 1003, a display panel 1005, a flame 1006, a circuit substrate 1007, and a battery 1008 between an upper cover 1001 and a lower cover 1009. The touch panel 1003 and the display panel 1005 are connected to flexible print circuits FPC 1002 and 1004, respectively. The circuit substrate 1007 has a transistor printed on it. The battery 1008 need not be provided if the display apparatus is not a display apparatus and may be provided at another position even if the apparatus is portable equipment.

The display apparatus according to the present embodiment may include red, green, and blue color filters. The red, green, and blue color filters may be arranged in a delta array.

The display apparatus according to the present embodiment may be used in the display unit of a portable terminal. In such a case, the display apparatus may have both display and operation functions. Examples of the portable terminal include a portable phone such as a smart phone, a tablet, and a head mount display.

The display apparatus according to the present embodiment may be used in a display unit of an image pickup apparatus that includes an optical portion including a plurality of lenses and an image pickup element receiving light passing through the optical portion. The image pickup apparatus may include a display unit that displays information acquired by the image pickup element. The display unit may be a display unit exposed to the outside of the image pickup apparatus or a display unit arranged in a finder. The image pickup apparatus may be a digital camera or a digital camcorder.

Fig. 3A is a schematic view illustrating an example of the image pickup apparatus according to the present invention. The image pickup apparatus 1100 includes a view finder 1101, a rear display 1102, an operating portion 1103, and a housing 1104. The view finder 1101 may include the display apparatus according to the present embodiment. In such a case, the display apparatus may display not only the image to be captured but also environmental information, an imaging instruction, and so on. The environmental information may be the intensity of external light, the direction of external light, the speed at which a photographic subject moves, the possibility that a photographic subject is shielded by a shielding material, and so on.

Since the optimal timing for image capturing is just a short time, it is better to display the information as soon as possible. Accordingly, it is preferable to use a display apparatus using the organic light-emitting element of the present

invention, because the response speed of the organic light-emitting element is high. The display apparatus using the organic light-emitting element can be used more suitably than a liquid crystal display apparatus that requires high display speed.

The image pickup apparatus 1100 includes an optical portion (not shown). The optical portion includes a plurality of lenses and forms an image in an image pickup element accommodated in a housing 1104. The lenses can adjust the focal point by adjusting the relative positions thereof. This operation can also be automatically performed. The image pickup apparatus may also be called a photoelectric conversion apparatus. The photoelectric conversion apparatus can adopt a method of detecting a difference from the previous image, a method of cutting out an image from images that are always being recorded, or the like as the method for capturing images, instead of sequentially capturing images.

Fig. 3B is a schematic view illustrating an example of electronic equipment according to the present invention. The electronic equipment 1200 includes a display unit 1201, an operation unit 1202, and a housing 1203. The housing 1203 may include a circuit, a print substrate having the circuit, a battery, and a communication unit. The operation unit 1202 may be a button or a touch panel-type reaction unit. The operation unit may be biometric unit that performs recognition of a fingerprint to unlock a lock. The electronic equipment including the communication unit can be also referred to as communication equipment. The electronic equipment may include a lens and an image pickup element to further have a camera function. An image captured by the camera function is displayed on the display unit. Examples of the electronic equipment include a smartphone and a laptop personal computer.

Figs. 4A and 4B are schematic views illustrating examples of a display apparatus according to the present invention. Fig. 4A illustrates a display apparatus such as a television monitor and a personal computer monitor. The display apparatus 1300 includes a frame 1301 and a display unit 1302. In the display unit 1302, a light emission device using the organic light-emitting element according to the present invention is used. The display apparatus 1300 includes a base 1303 that supports the frame 1301 and the display unit 1302. The base 1303 is not limited to the mode shown in Fig. 4A. The lower side of the frame 1301 may also serve as a base. The frame 1301 and the display unit 1302 may be curved. The curvature radius thereof may be 5000 mm or more and 6000 mm or less.

Fig. 4B is a schematic view illustrating another example of the display apparatus according to the present invention. The display apparatus 1310 of Fig. 4B is configured to be bendable and is a so-called foldable display apparatus. The display apparatus 1310 includes a first display unit 1311, a second display unit 1312, a housing 1313, and a folding point 1314. The first display unit 1311 and the second display unit 1312 include the light emission device using an organic light-emitting element according to the present invention. The first display unit 1311 and the second display unit 1312 may be one seamless display apparatus. The first display unit 1311 and the second display unit 1312 can be divided at the folding point. The first display unit 1311 and the second display unit 1312 may display mutually different images, or the first and second display units may display one image.

Fig. 5A is a schematic view illustrating an example of the illuminating apparatus according to the present invention. The illuminating apparatus 1400 includes a housing 1401, a light source 1402, a circuit substrate 1403, an optical filter 1404, and a light diffusion unit 1405. The light source 1402 includes the organic light-emitting element according to the present invention. The optical filter 1404 may be a filter to enhance the color rendering properties of the light source. The light diffusion unit 1405 can effectively diffuse the light of the light source 1402, such as lighting up, and can thereby deliver light to a wide range. The optical filter 1404 and the light diffusion unit 1405 may be disposed on the light emission side of an illumination light. As needed, a cover may be provided at the outermost portion.

The illuminating apparatus is, for example, an apparatus that illuminates the inside of a room. The illuminating apparatus may be an apparatus that emits light in any color of white, daylight white, and other colors from blue to red. The illuminating apparatus may include a light modulating circuit that modulates light in these colors. The illuminating apparatus includes the organic light-emitting element of the present invention and a power source circuit connected thereto. The power source circuit is a circuit that converts an AC voltage into a DC voltage. White has a color temperature of 4200 K, and daylight white has a color temperature of 5000 K. The illuminating apparatus may include a color filter.

The illuminating apparatus according to the present invention may include a heat dissipation portion. The heat dissipation portion releases heat in the apparatus to the outside, and examples thereof include a metal with a high specific heat and liquid silicon.

Fig. 5B is a schematic view illustrating an automobile as an example of a moving object according to the present invention. The automobile includes a tail lamp, which is an example of a lighting device. The automobile 1500 includes a tail lamp 1501, and the tail lamp may be in a mode in which the tail lamp is turned on when a braking operation or the like is performed.

The tail lamp 1501 includes the organic light-emitting element according to the present invention. The tail lamp may include a protective member that protects the organic light-emitting element. The material of the protective member is not limited as long as it has high strength to some extent and is transparent, but the protective member is preferably made of polycarbonate or the like. The polycarbonate may be mixed with a furandicarboxylic acid derivative, an acrylonitrile derivative, or the like.

The automobile 1500 may include a body 1503 and a window 1502 attached thereto. The window may be a

transparent display instead of a window for viewing the front and rear of the automobile. The transparent display includes the organic light-emitting element according to the present invention. The components of the organic light-emitting element, such as an electrode, are made of transparent members.

The moving object according to the present invention may be a ship, an airplane, a drone, or the like. The moving object includes a body and a lighting device mounted on the body. The lighting device emits light for notifying the position of the body. The lighting device includes the organic light-emitting element according to the present invention.

Application examples of the display apparatus of each of the above-described embodiments will be described with reference to Figs. 6A and 6B. The display apparatus can be applied to a system that can be worn as a wearable device such as smart glasses, a head mount display, and a smart contact lens. The image pickup and display apparatus that is used in such an application example includes an image pickup apparatus capable of photoelectrically converting visible light and a display apparatus capable of emitting visible light.

Fig. 6A illustrates glasses 1600 (smart glasses) according to one application example. The image pickup apparatus 1602, such as a complementary metal oxide semiconductor sensor and a single photon avalanche diode, is provided on the front side of the lens 1601 of the glasses 1600. The display apparatus of each of the above-described embodiments is provided on the rear side of the lens 1601.

The glasses 1600 further include a controller 1603. The controller 1603 functions as a power source that supplies power to the image pickup apparatus 1602 and the display apparatus according to each embodiment. The controller 1603 controls the operation of the image pickup apparatus 1602 and the display apparatus. An optical system for concentrating light in the image pickup apparatus 1602 is formed in the lens 1601.

Fig. 6B shows another embodiment of glasses 1610 (smart glasses). The glasses 1610 include a controller 1612, and an image pickup apparatus corresponding to the image pickup apparatus 1602 of Fig. 6A and a display apparatus are loaded on the controller 1612. In the lens 1611, the image pickup apparatus in the controller 1612 and an optical system for projecting the light emitted from the display apparatus are formed, and an image is projected to the lens 1611. The controller 1612 functions as a power source that supplies power to the image pickup apparatus and the display apparatus and also controls the operations of the image pickup apparatus and the display apparatus. The controller may include a gaze detection unit for detecting the wearer's gaze. The detection of a gaze may use infrared light. The infrared light-emitting unit emits infrared light toward an eyeball of a user gazing the displayed image. An image pickup unit including a light-receiving element detects reflected light of the emitted infrared light from the eyeball to obtain a pickup image of the eyeball. A decrease in the image quality is reduced by a device for reducing light from the infrared light-emitting unit to the display unit in a plan view.

The gaze of a user to the displayed image is detected from the pickup image of the eyeball obtained by capturing infrared light. An any known method can be used for the gaze detection using the pickup image of an eyeball. As an example, a gaze detection method based on the Purkinje image by reflection of irradiation light on the cornea can be used. More specifically, gaze detection treatment based on a pupil-cornea reflection method is performed. The gaze vector representing the direction (rotation angle) of an eyeball is calculated using the pupil-cornea reflection method based on the image of pupil included in the pickup image of the eyeball and the Purkinje image, and the gaze of the user is detected.

The display apparatus according to the present invention includes an image pickup apparatus including a light-receiving element and may control the displayed image on the display apparatus based on the gaze information of the user from the image pickup apparatus. Specifically, the display apparatus determines a first viewing region closely viewed by the user and a second viewing region other than the first viewing region based on the gaze information. The first viewing region and the second viewing region may be determined by the controller of the display apparatus, or may be received as those determined by an external controller. The display region of the display apparatus may be controlled such that the display resolution of the first viewing region is higher than the display resolution of the second viewing region. That is, the resolution of the second viewing region may be lower than that of the first viewing region.

The display region includes a first display region and a second display region different from the first display region, and a high-priority region is determined from the first display region and the second display region based on the gaze information. The first viewing region and the second viewing region may be determined by the controller of the display apparatus or may be received as those determined by an external controller. The resolution of the high-priority region may be controlled to be higher than the resolution of the region other than the high-priority region. That is, the resolution of a relatively low-priority region may be decreased.

The first viewing region and the high-priority region may be determined using AI. The AI may be a model configured so as to estimate the angle of the gaze from an image of the eyeball and the distance until a target in front of the gaze using the image of the eyeball and the direction actually viewed by the eyeball in the image as teaching data. The AI program may be included in the display apparatus, an image pickup apparatus, or an external apparatus. When the external apparatus includes the AI program, the AI program is transmitted to the display apparatus through communication.

When display is controlled based on visual detection, the display apparatus can be applied to smart glasses further including an image pickup apparatus for capturing an image of the outside. The smart glasses can display the

captured external information in real time.

Fig. 7A is a schematic view illustrating an example of an image formation apparatus according to one embodiment of the present invention. The image formation apparatus 1700 is an electrophotographic image formation apparatus and includes a photoreceptor 1707, an exposure light source 1708, a charging portion 1710, a developing portion 1711, a transfer device 1712, a transport roller 1713, and a fixing device 1715. Light 1709 is irradiated from the exposure light source 1708 to form an electrostatic latent image on the surface of the photoreceptor 1707. This exposure light source 1708 includes the organic light-emitting element according to the present invention. The development portion 1711 includes a toner or the like. The charging portion 1710 charges the photoreceptor 1707. The transfer device 1712 transfers the developed image to a recording medium 1714. The transport roller 1713 transports the recording medium 1714. The recording medium 1714 is, for example, paper. The fixing device 1715 fixes the image formed on the recording medium 1714.

Figs. 7B and 7C are diagrams each showing an exposure light source 1708 and are schematic views showing the state in which a plurality of light-emitting units 1726 are arranged on a long substrate. The arrow 1727 indicates a direction parallel to the axis of the photoreceptor and represents the column direction in which the organic light-emitting elements are arranged. This column direction is the same as the direction of the axis around which the photoreceptor 1707 rotates. This direction can also be called the longitudinal direction of the photoreceptor 1707. Fig. 7B shows a configuration in which the light-emitting units 1726 are arranged along the longitudinal direction of the photoreceptor 1707. Fig. 7C shows a configuration different from that of Fig. 7B and is a configuration in which light-emitting units 1726 are arranged alternately in the column direction in each of the first column and the second column. The first column and the second column are arranged in different positions in the row direction. In the first column, a plurality of light-emitting units 1726 are arranged with intervals. The second column includes light-emitting units 1726 at the positions corresponding to the intervals between the light-emitting units 1726 in the first column. That is, a plurality of light-emitting units 1726 are arranged with intervals also in the row direction. The arrangement of Fig. 7C can be rephrased as, for example, a lattice arrangement, a hound's-tooth check arrangement, or a checkered pattern.

As described above, display with good image quality and stable for a long time is possible by using an apparatus using the organic light-emitting element according to the present invention.

EXAMPLES

The present invention will be described by Example. However, the present invention is not limited to such Examples. Compounds used in Examples were synthesized according to known synthetic methods.

Table 1 shows HOMO levels and LUMO levels of light-emitting layer materials used in Examples. The HOMO level is the ionization potential value of a film of 50 nm thickness of each compound produced by a vacuum deposition method measured using RIKEN KEIKI Co., Ltd. AC-3. The LUMO level is the value obtained by measuring the absorption spectrum of a film produced as above and subtracting the optical absorption edge determined as the band gap from the ionization potential value.

[Table 1]

| Compound | HOMO(eV) | LUMO(eV) |
|---|---|---|
| EM1 | -6.0 | -3.1 |
| EM4 | -6.0 | -2.9 |
| EM22 | -6.1 | -3.0 |
| EM23 | -6.0 | -3.0 |
| B-1 | -6.1 | -3.3 |
| B-8 | -6.1 | -3.4 |
| B-20 | -6.1 | -3.5 |
| B-30 | -6.1 | -3.5 |
| B-33 | -6.1 | -3.4 |
| B-52 | -6.2 | -3.5 |
| G-7 | -5.9 | -3.5 |
| G-11 | -5.9 | -3.5 |
| G-14 | -5.9 | -3.4 |

(continued)

| Compound | HOMO(eV) | LUMO(eV) |
|---|---|---|
| G-15 | -5.8 | -3.4 |
| R-12 | -5.6 | -3.5 |
| R-18 | -5.6 | -3.6 |
| R-21 | -5.6 | -3.6 |

(Example 1)

In this Example, an organic light-emitting element of a top emission structure in which a positive electrode, a hole injection layer, a hole transport layer, an electron-blocking layer, a light-emitting layer, a hole-blocking layer, an electron transport layer, an electron injection layer, and a negative electrode were formed sequentially on a substrate was produced.

A Ti film of 40 nm thickness was formed on a glass substrate by a sputtering method and was patterned by photolithography technology to form a positive electrode. The positive electrode was adjusted to have an electrode area of 3 $mm^2$ and was then washed.

Subsequently, the substrate provided with the electrode produced above was attached to a vacuum deposition apparatus (manufactured by ULVAC, Inc.), deposition of a deposition material was prepared, and exhaustion was then performed to $1.33 \times 10^{-4}$ Pa ($1 \times 10^{-6}$ Torr). Subsequently, the inside of the chamber was subjected to UV/ozone washing. Then, each of the layers with the layer configurations shown in Table 2 were formed. Subsequently, the substrate was transferred to a glove box, and the glove box was sealed with a glass cap containing a desiccant in a nitrogen atmosphere to obtain an organic light-emitting element.

[Table 2]

| | Material | | | Thickness (nm) |
|---|---|---|---|---|
| Negative electrode | Al | | | 100 |
| Electron injection layer (EIL) | LiF | | | 1 |
| Electron transport layer (ETL) | ET2 | | | 15 |
| Hole-blocking layer (HBL) | ET12 | | | 15 |
| Second light-emitting layer | Second organic compound EM1 99.0 mass% | Third light-emitting material B-33 1.0 mass% | | 10 |
| First light-emitting layer | First organic compound EM1 97.9 mass% | First light-emitting material R-12 0.2 mass% | Second light-emitting material G-7 1.9 mass% | 15 |
| Electron-blocking layer (EBL) | HT12 | | | 15 |
| Hole transport layer (HTL) | HT3 | | | 30 |
| Hole injection layer (HIL) | HT16 | | | 5 |

The obtained organic light-emitting element was connected to a voltage application apparatus, and the characteristics thereof were evaluated. The current-voltage characteristic was measured with a microammeter 4140B manufactured by Hewlett-Packard, and the chromaticity was evaluated with "SR-3" manufactured by TOPCON Corporation. The light emission luminance was measured with BM7 manufactured by TOPCON Corporation. The current

efficiency that was determined from the current value energized and the light emission luminance when light with a luminance of 2000 cd/$m^2$ was emitted was 4.5 cd/A. Thus, the resulting organic white light-emitting element was good.

Furthermore, a continuous driving test was performed at an initial luminance of 2000 cd/$m^2$, and the luminance deterioration rate after 100 hours was measured. The results are shown in Table 3.

(Examples 2 to 22 and Comparative Examples 1 to 17)

Organic light-emitting elements were produced as in Example 1 except that the light-emitting layer of Example 1 changed to the configurations shown in Tables 3 to 5, and characteristics were evaluated. The results are shown in Tables 3 to 5.

The current efficiency was expressed as a ratio to the current efficiency of Example 5 set as 1.0, and the durability evaluation was expressed as a ratio to the luminance deterioration rate of Example 5 set as 1.0.

"ΔHOMO" in Tables 3 to 5 means the difference (HOMOd2 - HOMOh1) between the HOMO levels of the second light-emitting material and the first organic compound in the first light-emitting layer, and ΔLUMO" means the difference (LUMOh2 - LUMOd3) between the LUMO levels of the second organic compound and the third light-emitting material in the second light-emitting layer.

[Table 3]

| | First light-emitting layer | | | | Second light-emitting layer | | | ΔHOMO (eV) | ΔLUMO (eV) | Current efficiency | Durability |
|---|---|---|---|---|---|---|---|---|---|---|---|
| | First organic compound | First light-emitting material content (wt%) | Second light-emitting material content (wt%) | Thickness (nm) | Second organic compound | Third light-emitting material content (wt%) | Thickness (nm) | | | | |
| Example 1 | EM1 | R-12 0.2 | G-7 1.9 | 15 | EM1 | B-33 1.0 | 10 | 0.1 | 0.3 | 1.0 | 1.1 |
| Example 2 | EM1 | R-12 0.2 | G-7 1.6 | 15 | EM1 | B-33 1.0 | 10 | 0.1 | 0.3 | 1.1 | 1.2 |
| Example 3 | EM1 | R-12 0.2 | G-7 1.0 | 15 | EM1 | B-33 1.0 | 10 | 0.1 | 0.3 | 1.0 | 1.1 |
| Comparative Example 1 | EM1 | R-12 0.2 | G-7 0.2 | 15 | EM1 | B-33 1.0 | 10 | 0.1 | 0.3 | 0.1 | 0.7 |
| Comparative Example 2 | EM1 | R-12 0.2 | G-7 2.0 | 15 | EM1 | B-33 1.0 | 10 | 0.1 | 0.3 | 0.9 | 0.9 |
| Comparative Example 3 | EM1 | R-12 0.2 | G-7 2.4 | 15 | EM1 | B-33 1.0 | 10 | 0.1 | 0.3 | 0.7 | 0.8 |
| Example 4 | EM1 | R-12 0.2 | G-7 1.6 | 15 | EM1 | B-33 1.3 | 10 | 0.1 | 0.3 | 1.2 | 1.2 |
| Example 5 | EM1 | R-12 0.2 | G-7 1.6 | 15 | EM1 | B-33 0.7 | 10 | 0.1 | 0.3 | 1.0 | 1.0 |
| Comparative Example 4 | EM1 | R-12 0.2 | G-7 1.6 | 15 | EM1 | B-33 0.2 | 10 | 0.1 | 0.3 | 0.5 | 0.8 |
| Example 6 | EM1 | R-12 0.2 | G-7 1.6 | 15 | EM1 | B-33 2.0 | 10 | 0.1 | 0.3 | 1.1 | 1.1 |
| Example 7 | EM1 | R-12 0.3 | G-7 1.6 | 15 | EM1 | B-33 1.0 | 10 | 0.1 | 0.3 | 0.8 | 1.1 |
| Example 8 | EM1 | R-12 0.1 | G-7 1.6 | 15 | EM1 | B-33 1.0 | 10 | 0.1 | 0.3 | 1.2 | 1.2 |

[Table 4]

| | First light-emitting layer | | | | Second light-emitting layer | | | ΔHOMO (eV) | ΔLUMO (eV) | Current efficiency | Durability |
|---|---|---|---|---|---|---|---|---|---|---|---|
| | First organic compound | First light-emitting material content (wt%) | Second light-emitting material content (wt%) | Thickness (nm) | Second organic compound | Third light-emitting material content (wt%) | Thickness (nm) | | | | |
| Example 9 | EM1 | R-12 0.2 | G-7 1.6 | 13 | EM1 | B-33 1.0 | 10 | 0.1 | 0.3 | 1.0 | 1.1 |
| Example 10 | EM1 | R-12 0.2 | G-7 1.6 | 11 | EM1 | B-33 1.0 | 10 | 0.1 | 0.3 | 1.0 | 1.0 |
| Example 11 | EM1 | R-12 0.2 | G-7 1.6 | 10 | EM1 | B-33 1.0 | 10 | 0.1 | 0.3 | 1.0 | 1.0 |
| Example 12 | EM1 | R-12 0.2 | G-7 1.6 | 15 | EM1 | B-52 1.0 | 10 | 0.1 | 0.4 | 1.1 | 1.2 |
| Comparative Example 5 | EM1 | R-12 0.2 | G-7 2.0 | 15 | EM1 | B-52 1.0 | 10 | 0.1 | 0.4 | 0.9 | 0.9 |
| Example 13 | EM1 | R-12 0.2 | G-7 1.6 | 15 | EM1 | B-1 1.9 | 10 | 0.1 | 0.2 | 1.0 | 1.1 |
| Comparative Example 6 | EM1 | R-12 0.2 | G-7 2.0 | 15 | EM1 | B-1 1.9 | 10 | 0.1 | 0.2 | 0.9 | 0.9 |
| Example 14 | EM1 | R-12 0.2 | G-7 1.6 | 15 | EM1 | B-8 1.5 | 10 | 0.1 | 0.3 | 1.1 | 1.1 |
| Comparative Example 7 | EM1 | R-12 0.2 | G-7 2.0 | 15 | EM1 | B-8 1.5 | 10 | 0.1 | 0.3 | 0.9 | 0.9 |
| Example 15 | EM1 | R-12 0.2 | G-7 1.6 | 15 | EM1 | B-30 1.5 | 10 | 0.1 | 0.4 | 1.1 | 1.2 |
| Comparative Example 8 | EM1 | R-12 0.2 | G-7 2.0 | 15 | EM1 | B-30 1.5 | 10 | 0.1 | 0.4 | 0.9 | 0.9 |
| Example 16 | EM1 | R-12 0.2 | G-7 1.6 | 15 | EM1 | B-20 1.5 | 10 | 0.1 | 0.4 | 1.0 | 1.2 |

(continued)

| | First light-emitting layer | | | | Second light-emitting layer | | | ΔHOMO (eV) | ΔLUMO (eV) | Current efficiency | Durability |
|---|---|---|---|---|---|---|---|---|---|---|---|
| | First organic compound | First light-emitting material content (wt%) | Second light-emitting material content (wt%) | Thickness (nm) | Second organic compound | Third light-emitting material content (wt%) | Thickness (nm) | | | | |
| Comparative Example 9 | EM1 | R-12 0.2 | G-7 2.0 | 15 | EM1 | B-20 1.5 | 10 | 0.1 | 0.4 | 0.9 | 0.9 |

[Table 5]

| | First light-emitting layer | | | | Second light-emitting layer | | | ΔHOMO (eV) | ΔLUMO (eV) | Current efficiency | Durability |
|---|---|---|---|---|---|---|---|---|---|---|---|
| | First organic compound | First light-emitting material content (wt%) | Second light-emitting material content (wt%) | Thickness (nm) | Second organic compound | Third light-emitting material content (wt%) | Thickness (nm) | | | | |
| Example 17 | EM1 | R-12 0.2 | G-15 1.6 | 15 | EM1 | B-33 1.0 | 10 | 0.2 | 0.3 | 1.0 | 1.1 |
| Comparative Example 10 | EM1 | R-12 0.2 | G-15 2.2 | 15 | EM1 | B-33 1.0 | 10 | 0.2 | 0.3 | 0.9 | 0.8 |
| Example 18 | EM1 | R-12 0.2 | G-14 1.6 | 15 | EM1 | B-33 1.0 | 10 | 0.1 | 0.3 | 1.1 | 1.1 |
| Comparative Example 11 | EM1 | R-12 0.2 | G-14 2.2 | 15 | EM1 | B-33 1.0 | 10 | 0.1 | 0.3 | 0.9 | 0.9 |
| Example 19 | EM1 | R-21 0.2 | G-7 1.6 | 15 | EM1 | B-33 1.0 | 10 | 0.1 | 0.3 | 1.0 | 1.2 |
| Comparative Example 12 | EM1 | R-21 0.2 | G-7 2.0 | 15 | EM1 | B-33 1.0 | 10 | 0.1 | 0.3 | 0.9 | 0.9 |
| Example 20 | EM22 | R-18 0.1 | G-11 1.6 | 15 | EM22 | B-30 1.3 | 10 | 0.2 | 0.5 | 1.1 | 1.3 |
| Comparative Example 13 | EM22 | R-18 0.1 | G-11 2.2 | 15 | EM22 | B-30 1.3 | 10 | 0.2 | 0.5 | 0.9 | 0.9 |
| Example 21 | EM23 | R-18 0.1 | G-11 1.6 | 15 | EM23 | B-33 1.3 | 10 | 0.1 | 0.4 | 1.1 | 1.2 |
| Comparative Example 14 | EM23 | R-18 0.1 | G-11 2.2 | 15 | EM23 | B-33 1.3 | 10 | 0.1 | 0.4 | 0.9 | 0.9 |
| Example 22 | EM4 | R-12 0.2 | G-7 1.6 | 15 | EM4 | B-1 1.5 | 10 | 0.1 | 0.4 | 1.1 | 1.1 |
| Comparative Example 15 | EM4 | R-12 0.2 | G-7 2.2 | 15 | EM4 | B-1 1.5 | 10 | 0.1 | 0.4 | 0.9 | 0.9 |

(continued)

| | First light-emitting layer | | | | Second light-emitting layer | | | ΔHOMO (eV) | ΔLUMO (eV) | Current efficiency | Durability |
|---|---|---|---|---|---|---|---|---|---|---|---|
| | First organic compound | First light-emitting material content (wt%) | Second light-emitting material content (wt%) | Thickness (nm) | Second organic compound | Third light-emitting material content (wt%) | Thickness (nm) | | | | |
| Comparative Example 16 | EM1 | R-12 0.2 | G-15 1.8 | 15 | EM1 | B-1 1.9 | 10 | 0.2 | 0.2 | 0.8 | 0.6 |
| Comparative Example 17 | EM23 | R-12 0.2 | G-15 1.8 | 15 | EM1 | B-1 1.9 | 10 | 0.2 | 0.2 | 0.9 | 0.7 |

It was demonstrated from Examples 1 to 3 and Comparative Examples 2 and 3 that both the current efficiency and the durability characteristic are improved when the content of the second light-emitting material is less than 2.0 mass%. This is because that a low content of the second light-emitting material improves the hole-trapping property of the first light-emitting layer and that deterioration of the electron-blocking layer occurs by approaching of the recombination region to the interface between the first light-emitting layer and the electron-blocking layer.

As in Comparative Example 1, when the contents of the first light-emitting material and the second light-emitting material are the same, the balance of red, green, and blue light emission is greatly disrupted to significantly reduce the current efficiency, which is undesirable.

It was demonstrated from Examples 4 to 6 and Comparative Example 4 that a high content of the third light-emitting material improves the current efficiency and durability characteristic. This is because that a high content of the third light-emitting material improves the electron-trapping property of the second light-emitting layer and that the deterioration of the electron-blocking layer can be reduced by keeping the recombination region away from the interface between the first light-emitting layer and the electron-blocking layer.

As shown in Examples 7 and 8, since the current efficiency is reduced by concentration quenching when the content of the first light-emitting material is high, the content is preferably less than 0.3 mass% and is preferably less than 0.2 mass%.

It was demonstrated from Examples 9 to 11 that the durability characteristic is improved when the thickness of the first light-emitting layer is large with respect to that of the second light-emitting layer. This is because that since the recombination region is kept away from the interface between the first light-emitting layer and the electron-blocking layer by a large thickness of the first light-emitting layer, the deterioration of the electron-blocking layer can be reduced.

As shown in Comparative Examples 5 to 15, if the expression [4] is not satisfied, the current efficiency and the durability characteristic are deteriorated. This is because that charges are not confined in the light-emitting layer and that the hole-trapping ability of the first light-emitting layer is not sufficiently mitigated to cause recombination at the interface with the electron-blocking layer.

It was found from the above that in the organic light-emitting element of the present invention, the durability characteristic is improved by keeping the recombination region small away from the interface of the first light-emitting layer with the electron-blocking layer in addition to containment of charges in the light-emitting layer and delocalization of the recombination region. Accordingly, the hole-trapping ability of the first light-emitting layer is mitigated by decreasing the content of the light-emitting material in the first light-emitting layer, the recombination region recedes from the interface by strengthening the electron-trapping ability of the second light-emitting layer, and, consequently, the driving durability characteristic can be improved.

(Examples 23 to 29 and Comparative Examples 18 to 20)

Organic light-emitting elements were produced as in Examples 2, 22, and 18 except that the adjacent layer was changed to the materials shown in Table 6, and the characteristics were evaluated. The results are shown in Table 6.

[Table 6]

| | First light-emitting layer | | | | Second light-emitting layer | | | Adjacent layer | Current efficiency | Durability |
|---|---|---|---|---|---|---|---|---|---|---|
| | First organic compound | First light-emitting material content (wt%) | Second light-emitting material content (wt%) | Thickness (nm) | Second organic compound | Third light-emitting material content (%) | Thickness (nm) | | | |
| Example 2 | EM1 | R-12 0.2 | G-7 1.6 | 15 | EM1 | B-33 1.0 | 10 | ET12 | 1.1 | 1.2 |
| Example 23 | EM1 | R-12 0.2 | G-7 1.6 | 15 | EM1 | B-33 1.0 | 10 | EM4 | 1.1 | 1.2 |
| Example 24 | EM1 | R-12 0.2 | G-7 1.6 | 15 | EM1 | B-33 1.0 | 10 | EM10 | 1.1 | 1.2 |
| Example 25 | EM1 | R-12 0.2 | G-7 1.6 | 15 | EM1 | B-33 1.0 | 10 | EM12 | 1.1 | 1.2 |
| Example 26 | EM1 | R-12 0.2 | G-7 1.6 | 15 | EM1 | B-33 1.0 | 10 | EM1 | 1.1 | 1.1 |
| Example 27 | EM1 | R-12 0.2 | G-7 1.6 | 15 | EM1 | B-33 1.0 | 10 | EM5 | 1.1 | 1.0 |
| Comparative Example 18 | EM1 | R-12 0.2 | G-7 1.6 | 15 | EM1 | B-33 1.0 | 10 | ET3 | 0.9 | 0.5 |
| Example 22 | EM4 | R-12 0.2 | G-7 1.6 | 15 | EM4 | B-1 1.5 | 10 | ET12 | 1.1 | 1.1 |
| Example 28 | EM4 | R-12 0.2 | G-7 1.6 | 15 | EM4 | B-1 1.5 | 10 | ET22 | 1.1 | 1.0 |
| Comparative Example 19 | EM4 | R-12 0.2 | G-7 1.6 | 15 | EM4 | B-1 1.5 | 10 | ET17 | 0.9 | 0.8 |
| Example 20 | EM22 | R-18 0.1 | G-11 1.6 | 15 | EM22 | B-30 1.3 | 10 | ET12 | 1.1 | 1.3 |
| Example 29 | EM22 | R-18 0.1 | G-11 1.6 | 15 | EM22 | B-30 1.3 | 10 | EM3 | 1.1 | 1.1 |
| Comparative Example 20 | EM22 | R-18 0.1 | G-11 1.6 | 15 | EM22 | B-30 1.3 | 10 | ET8 | 0.9 | 0.7 |

In Examples 2 and 23 to 27, the efficiency and durability were improved compared to Comparative Example 18, even though the materials of the light-emitting layers were the same. This is because that the adjacent layer of Comparative Example 18 is a compound having a hetero atom and having high chemical reactivity to easily cause deterioration during operation. In contrast, the adjacent layers of Examples 2 and 23 to 27 are compounds composed of hydrocarbon and having high stability to suppress deterioration during operation.

In Examples 22, 28, 20, and 29 and Comparative Examples 19 and 20, which are different in the configurations of the light-emitting layers, the same effect was observed.

(Examples 30 and 31 and Comparative Examples 21 to 29)

Organic light-emitting elements were produced as in Example 2 except that the materials and concentrations of the light-emitting layers and the adjacent layers were changed to those shown in Table 7, and the characteristics were evaluated. The results are shown in Table 7.

[Table 7]

| | First light-emitting layer | | | | Second light-emitting layer | | | Adjacent layer | Current efficiency | Durability |
|---|---|---|---|---|---|---|---|---|---|---|
| | First organic compound | First light-emitting material content (wt%) | Second light-emitting material content (wt%) | Thickness (nm) | Second organic compound | Third light-emitting material content (%) | Thickness (nm) | | | |
| Example 2 | EM1 | R-12 0.2 | G-7 1.6 | 15 | EM1 | B-33 1.0 | 10 | ET12 | 1.1 | 1.2 |
| Comparative Example 21 | EM1 | R-12 0.2 | G-7 2.0 | 15 | EM1 | B-33 1.0 | 10 | ET12 | 1.0 | 1 |
| Comparative Example 22 | EM1 | R-12 0.2 | G-7 2.2 | 15 | EM1 | B-33 1.0 | 10 | ET12 | 1.0 | 0.9 |
| Comparative Example 23 | EM1 | R-12 0.2 | G-7 3.0 | 15 | EM1 | B-33 1.0 | 10 | ET12 | 0.9 | 0.7 |
| Comparative Example 18 | EM1 | R-12 0.2 | G-7 1.6 | 15 | EM1 | B-33 1.0 | 10 | ET3 | 0.9 | 0.5 |
| Comparative Example 24 | EM1 | R-12 0.2 | G-7 3.0 | 15 | EM1 | B-33 1.0 | 10 | ET3 | 0.8 | 0.3 |
| Example 30 | EM1 | R-12 0.2 | G-7 1.6 | 15 | EM1 | B-10 1.0 | 10 | ET12 | 0.9 | 0.7 |
| Comparative Example 25 | EM1 | R-12 0.2 | G-7 1.6 | 15 | EM1 | B-10 1.0 | 10 | ET3 | 0.8 | 0.5 |
| Comparative Example 26 | EM1 | R-12 0.2 | G-7 3.0 | 15 | EM1 | B-10 1.0 | 10 | ET12 | 0.7 | 0.4 |
| Comparative Example 27 | EM1 | R-12 0.2 | G-7 3.0 | 15 | EM1 | B-10 1.0 | 10 | ET3 | 0.7 | 0.3 |
| Example 31 | EM1 | R-12 0.3 | G-7 1.6 | 15 | EM1 | B-33 0.2 | 10 | ET12 | 0.5 | 0.5 |
| Comparative Example 28 | EM1 | R-12 0.3 | G-7 3.0 | 15 | EM1 | B-33 0.2 | 10 | ET12 | 0.4 | 0.4 |
| Comparative Example 29 | EM1 | R-12 0.3 | G-7 1.6 | 15 | EM1 | B-33 0.2 | 10 | ET3 | 0.4 | 0.3 |

Example 2 and Comparative Examples 21 to 23 are examples in which the concentration of the second light-emitting material of the first light-emitting layer was changed. The efficiency and durability were improved with a decrease in the concentration of the second light-emitting material to less than 2%. This is because that a decrease in the concentration of the second light-emitting material reduces the hole-trapping ability of the first light-emitting layer and shifts the recombination region towards the second light-emitting layer side (recedes from the electron-blocking layer).
In Comparative Examples 18 and 24, the adjacent layer was further changed from a stable hydrocarbon compound to a hetero atom-containing compound, and the efficiency and durability were deteriorated compared to Example 2 and Comparative Example 23. This is because that as described above, the adjacent layer is a hetero atom-containing compound and is easily deteriorated.
In Example 30 and Comparative Examples 25 to 27, the third light-emitting material was changed. Even if the molecular structure of the third light-emitting material was largely changed, the same effect was obtained due to the concentration of the second light-emitting material and the adjacent layer composed of hydrocarbon.
In Example 31 and Comparative Examples 28 and 29, the relationship between the concentrations of the third light-emitting material and the first light-emitting material was changed. Regardless of the concentrations of these light-emitting materials, the same effect was obtained due to the concentration of the second light-emitting material and the adjacent layer composed of hydrocarbon.
The present invention is not limited to the above-described embodiments, various changes and modifications are possible without departing from the spirit and scope of the present invention. Accordingly, in order to make the scope of the present invention public, the following claims are appended.
This application claims the benefit of Japanese Patent Application No. 2023-015298 filed February 3, 2023 and No. 2023-139102 filed August 29, 2023, which are hereby incorporated by reference herein in their entirety.

Reference Signs List

12 first electrode
15 second electrode
18, 36 organic light-emitting element
1000, 1300, 1310 display apparatus
1100 image pickup apparatus
1104, 1203, 1313 housing
1200 electronic equipment
1201, 1302, 1311, 1312 display unit
1402 light source
1404 optical filter
1405 light diffusion unit

## Claims

**1.** An organic light-emitting element comprising a first electrode, a first light-emitting layer, a second light-emitting layer, and a second electrode in this order, wherein the first light-emitting layer includes a first organic compound, a first light-emitting material, and a second light-emitting material, the second light-emitting layer includes a second organic compound and a third light-emitting material, and following expressions [1] to [4] are satisfied:

$$[1]\ (HOMOd2 - HOMOh1) < (LUMOh2 - LUMOd3);$$

a content of the first light-emitting material < a content of the second light-emitting material; [2]

a content of the first light-emitting material < a content of the third light-emitting material; [3]

and

a content of the second light-emitting material < 2.0 mass%, [4]

HOMOh1: a HOMO level of the first organic compound;
HOMOd2: a HOMO level of the second light-emitting material;
LUMOh2: a LUMO level of the second organic compound; and
LUMOd3: a LUMO level of the third light-emitting material.

2. The organic light-emitting element according to claim 1, comprising an adjacent layer on the second electrode side of the second light-emitting layer, wherein the adjacent layer is made of an organic compound composed of hydrocarbon.

3. An organic light-emitting element comprising a first electrode, a first light-emitting layer, a second light-emitting layer, an adjacent layer, and a second electrode in this order, wherein the first light-emitting layer includes a first organic compound, a first light-emitting material, and a second light-emitting material, the second light-emitting layer includes a second organic compound and a third light-emitting material, the adjacent layer is made of an organic compound composed of hydrocarbon, and a following expression [4] is satisfied:

a content of the second light-emitting material < 2.0 mass%. [4]

4. The organic light-emitting element according to claim 2 or 3, wherein the organic compound composed of hydrocarbon includes a fused-polycyclic aromatic ring with four or more rings.

5. The organic light-emitting element according to claim 2 or 3, wherein the organic compound composed of hydrocarbon is made of $sp^2$ carbon only.

6. The organic light-emitting element according to claim 1 or 3, comprising a layer including an arylamine derivative on the first electrode side of the first light-emitting layer.

7. The organic light-emitting element according to claim 1 or 3, wherein a content of the third light-emitting material is 1.0 mass% or more.

8. The organic light-emitting element according to claim 1 or 3, wherein a content of the first light-emitting material is less than 0.3 mass%.

9. The organic light-emitting element according to claim 1 or 3, wherein the first light-emitting layer has a thickness larger than that of the second light-emitting layer.

10. The organic light-emitting element according to claim 1 or 3, wherein the first organic compound and the second organic compound are the same compounds.

11. The organic light-emitting element according to claim 1 or 3, wherein the first light-emitting material, the second light-emitting material, and the third light-emitting material each include a fluoranthene skeleton.

12. The organic light-emitting element according to claim 1 or 3, wherein the first organic compound and the second organic compound each include a pyrene skeleton.

13. The organic light-emitting element according to claim 1 or 3, wherein compounds constituting the first light-emitting layer and the second light-emitting layer are all hydrocarbon.

14. The organic light-emitting element according to claim 1 or 3, wherein in the first organic compound and the second organic compound, freely rotatable single bonds are all carbon-carbon bonds, and at least one carbon of the carbon-carbon bond is $sp^2$ carbon.

15. A display apparatus comprising a plurality of pixels, wherein at least one of the pixels includes the organic light-emitting element according to any one of claims 1 to 14 and a transistor connected to the organic light-emitting element.

16. A photoelectric conversion apparatus comprising an optical portion including a plurality of lenses, an image pickup

element receiving light passed through the optical portion, and a display unit displaying an image captured by the image pickup element, wherein the display unit includes the organic light-emitting element according to any one of claims 1 to 14.

**17.** Electronic equipment comprising a display unit including the organic light-emitting element according to any one of claims 1 to 14, a housing in which the display unit is disposed, and a communication unit disposed in the housing and communicating with the outside.

**18.** An illuminating apparatus comprising a light source including the organic light-emitting element according to any one of claims 1 to 14 and a light diffusion unit or an optical filter through which light emitted from the light source penetrates.

**19.** A moving object comprising a lighting device including the organic light-emitting element according to any one of claims 1 to 14 and a body provided with the lighting device.

**20.** An image formation apparatus comprising a photoreceptor and an exposure light source exposing the photoreceptor to light, wherein the exposure light source includes the organic light-emitting element according to any one of claims 1 to 14.

FIG. 1A

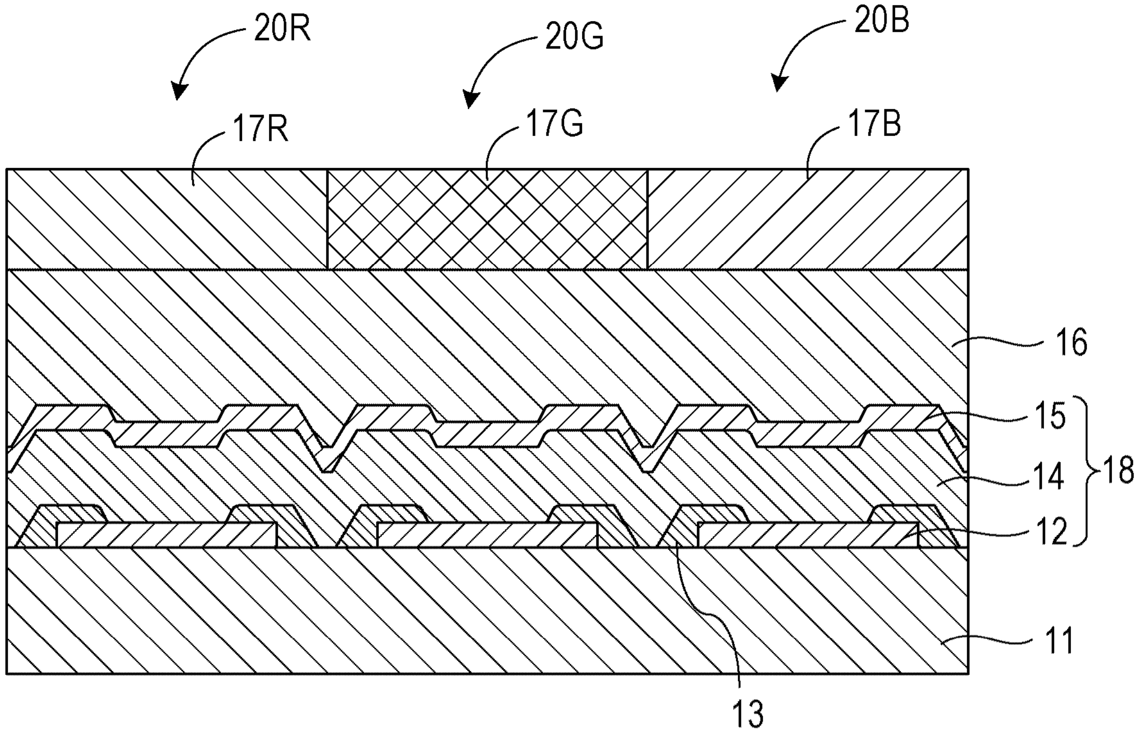
20R
20G
20B
17R
17G
17B
16
15
14
18
12
11
13

FIG. 1B

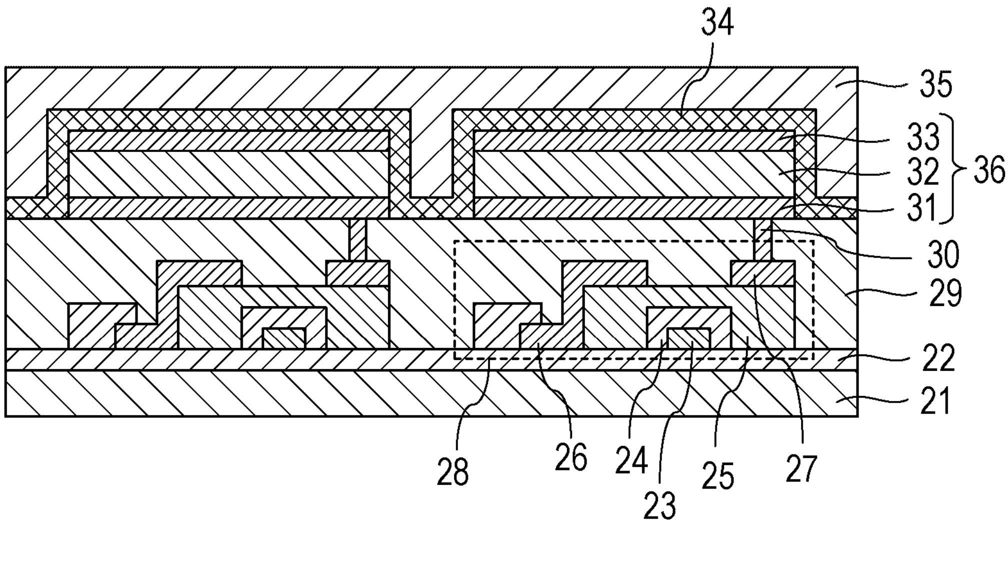
34
35
33
32
36
31
30
29
22
21
28
26
24
23
25
27

FIG. 2

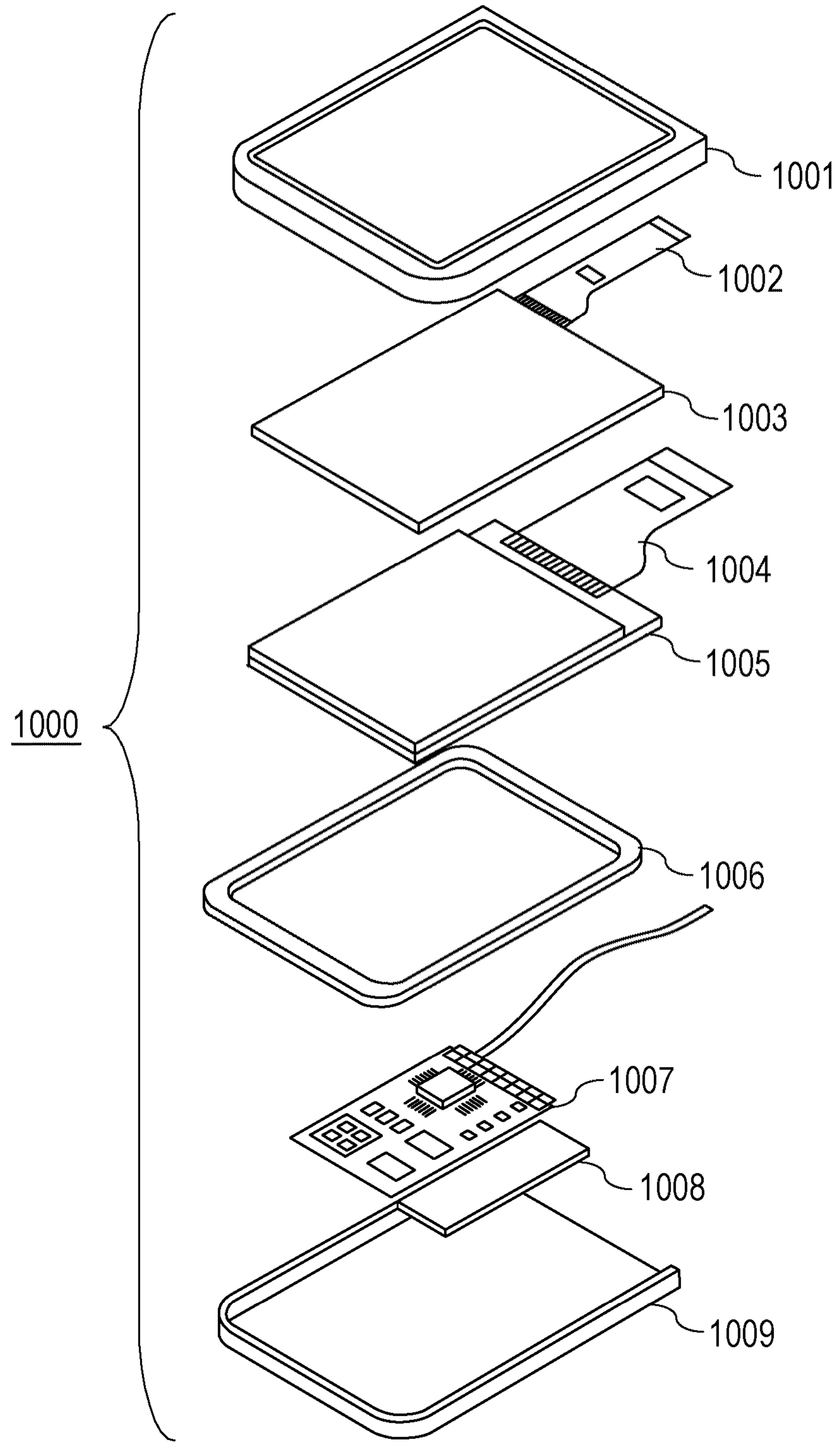

FIG. 3A

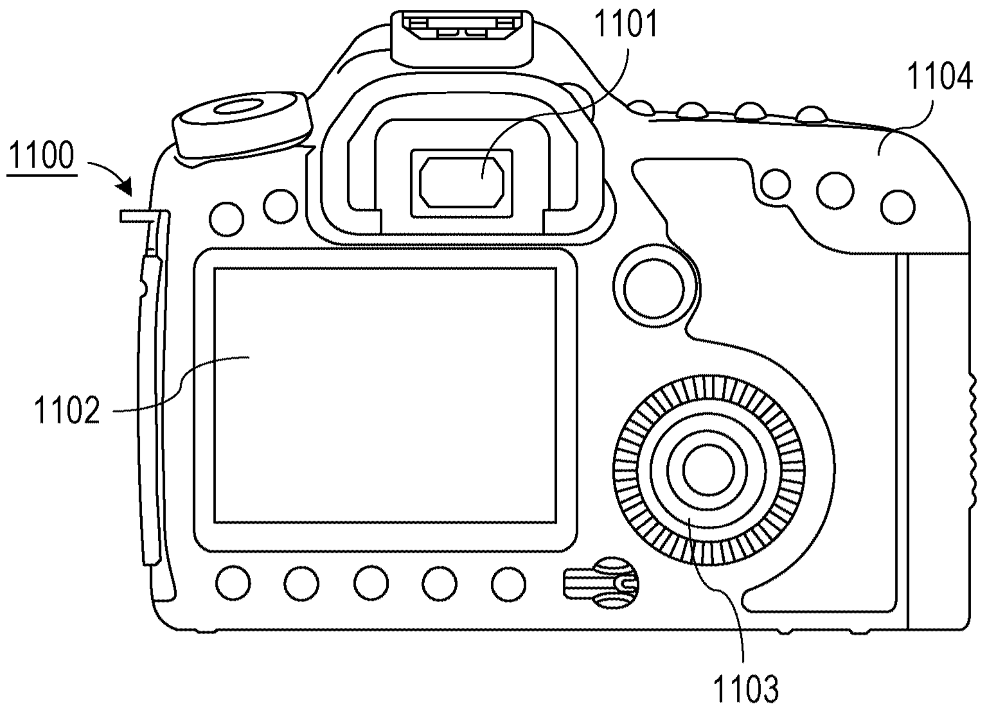


FIG. 3B

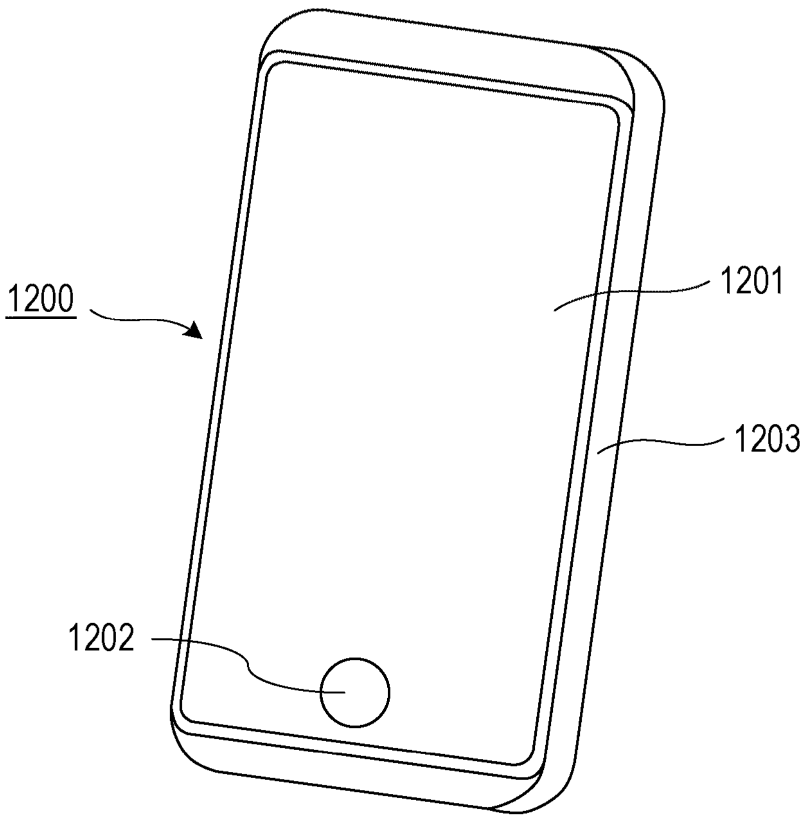

FIG. 4A

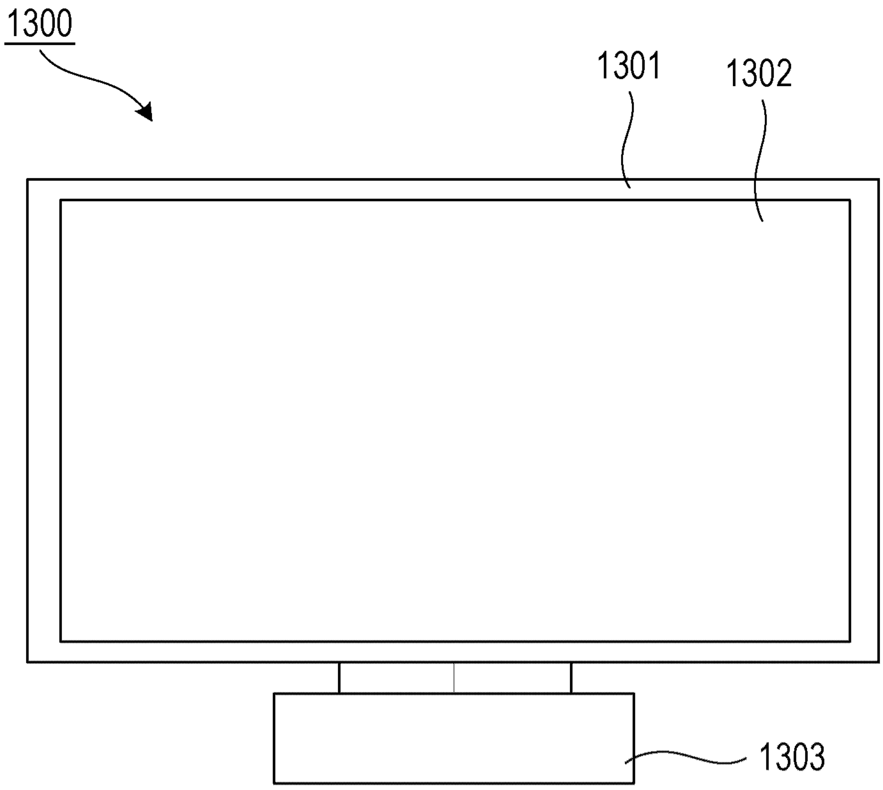


FIG. 4B

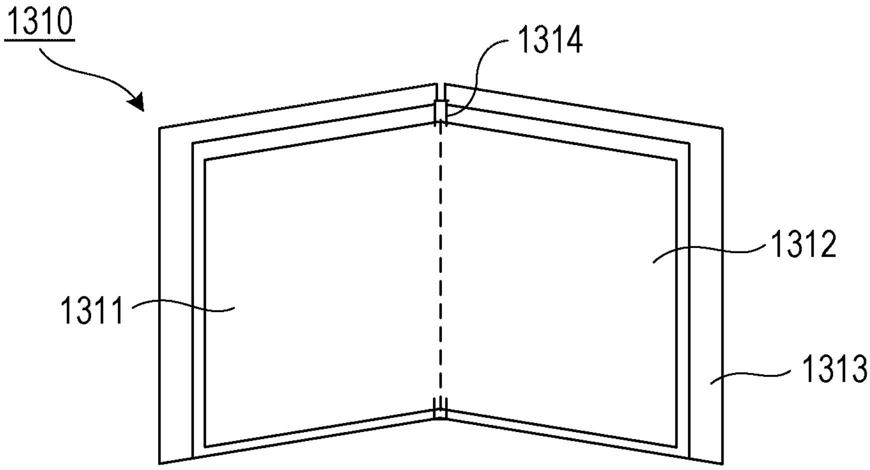

FIG. 5A

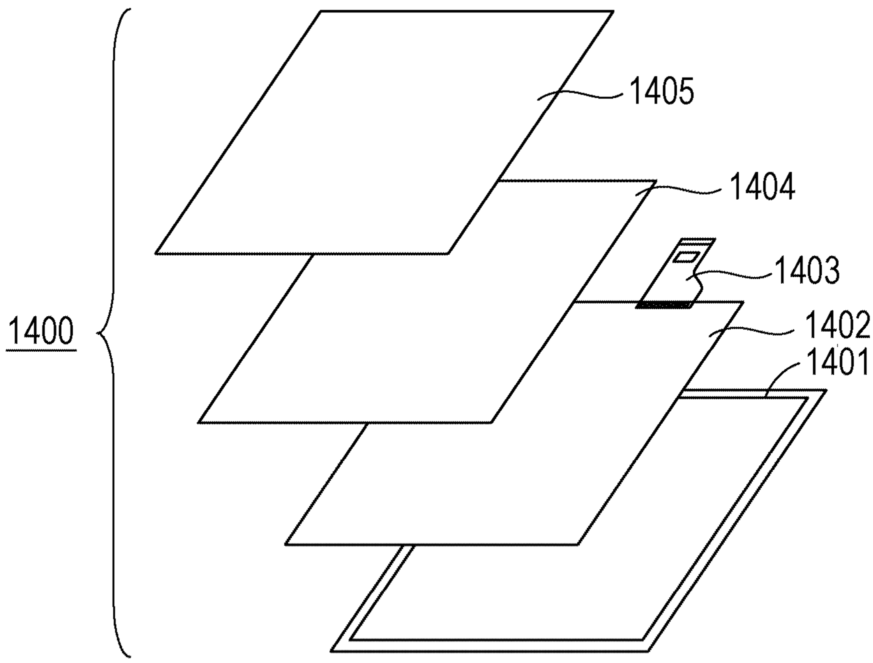


FIG. 5B

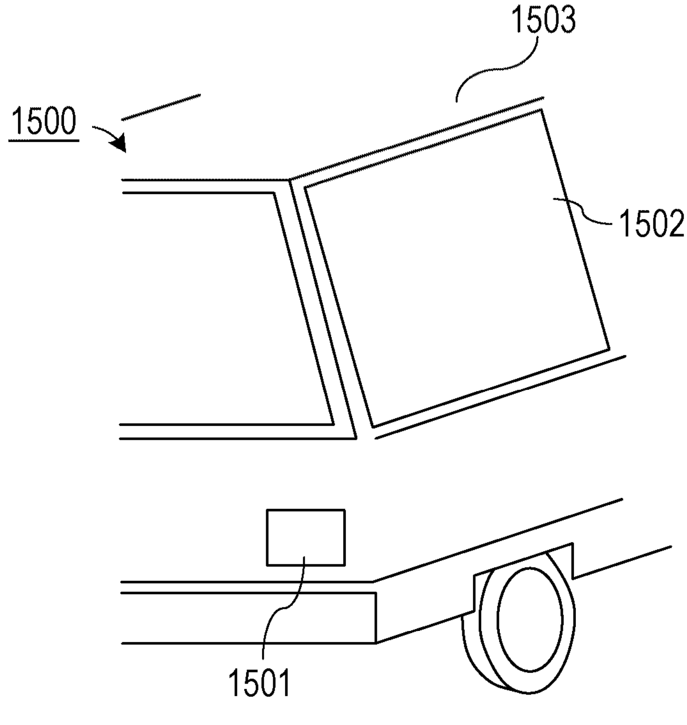

FIG. 6A

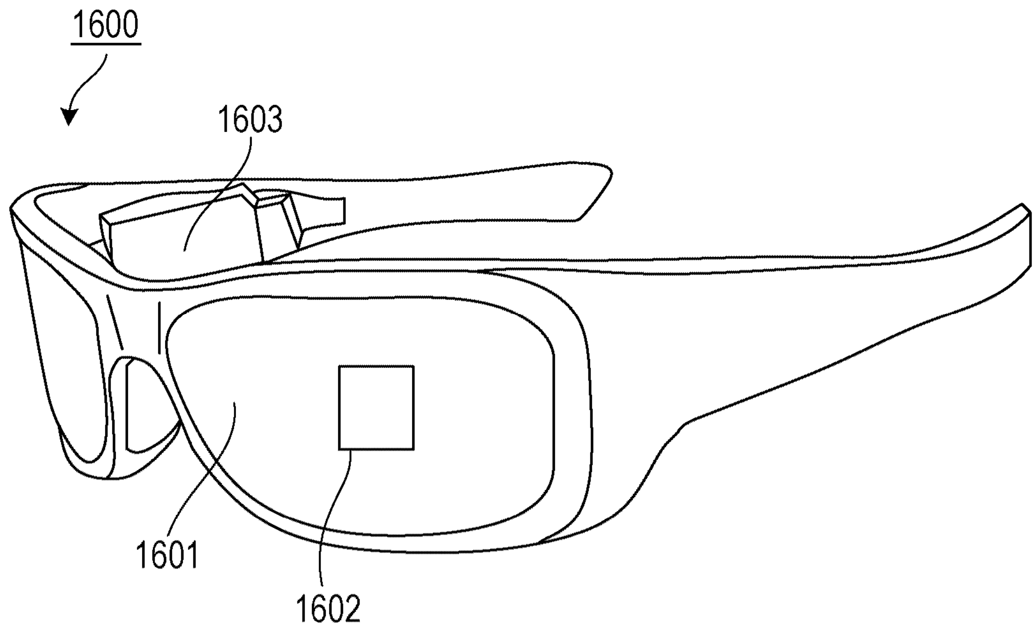


FIG. 6B

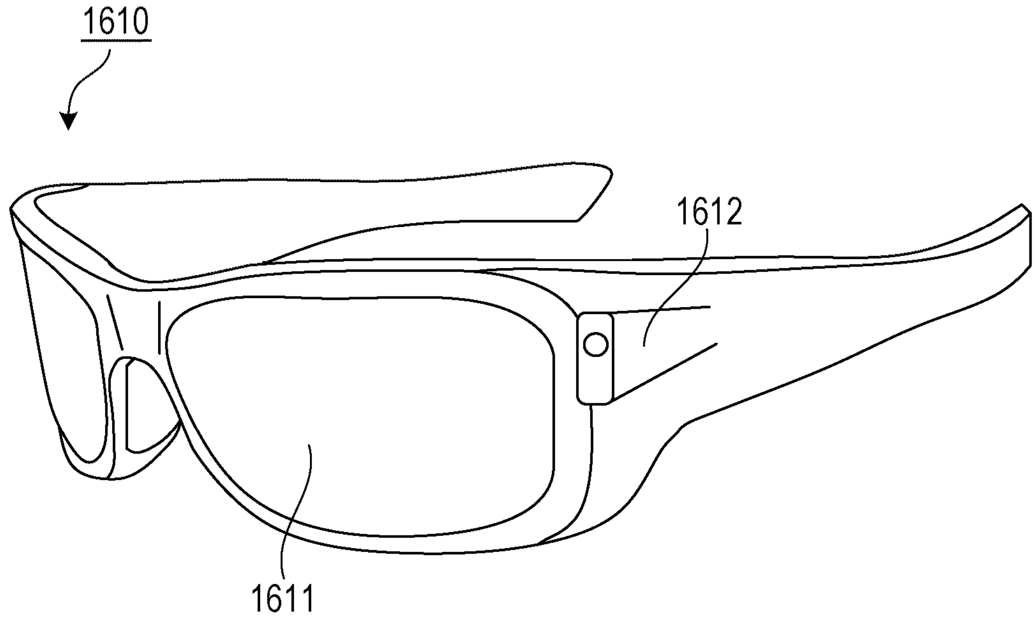

FIG. 7A

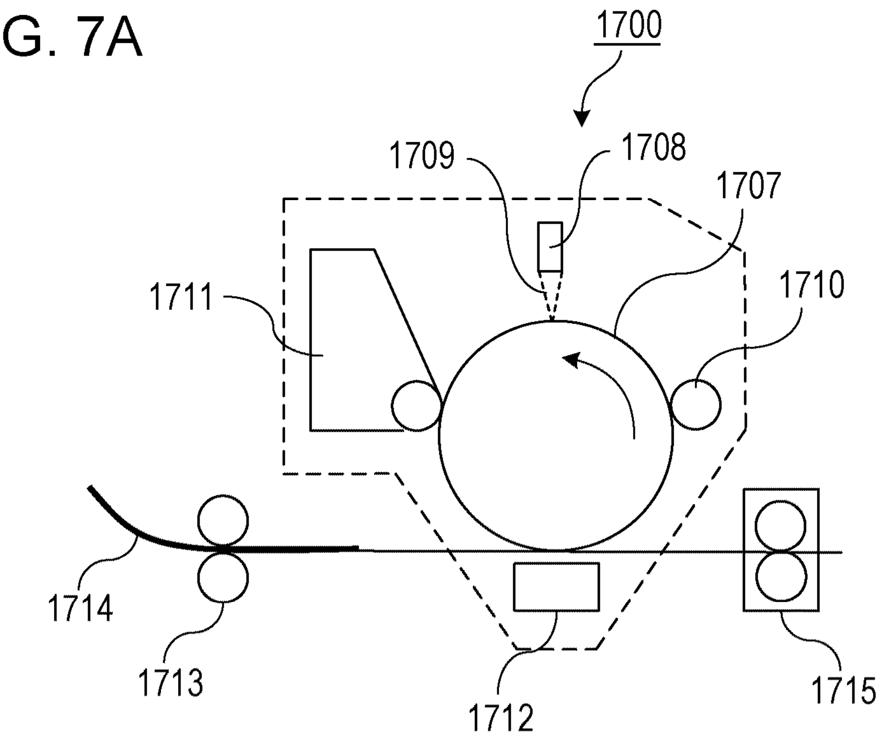


FIG. 7B

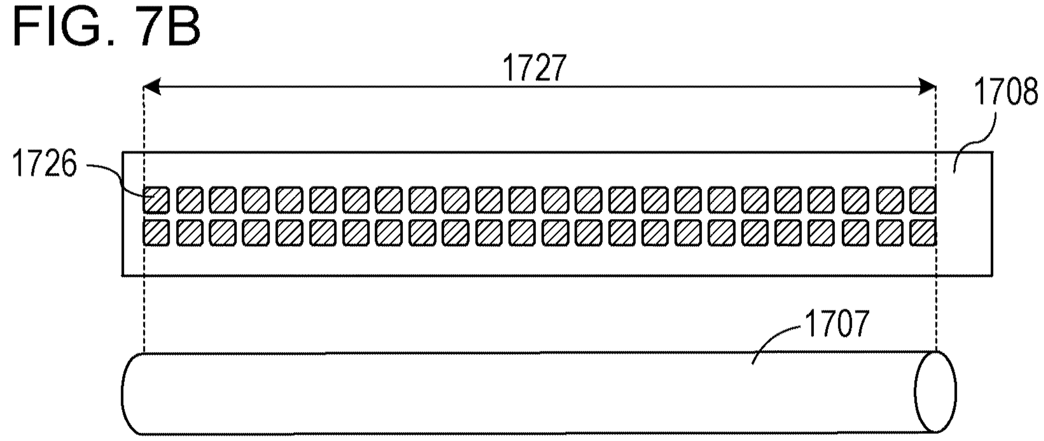


FIG. 7C

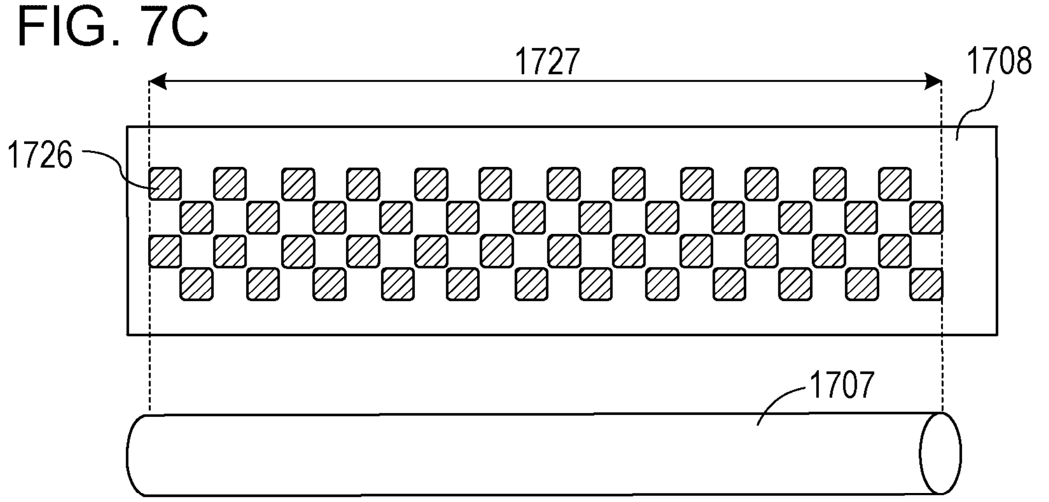

## INTERNATIONAL SEARCH REPORT

International application No.
**PCT/JP2024/002634**

### A. CLASSIFICATION OF SUBJECT MATTER

***H10K 50/13***(2023.01)i; ***G09F 9/30***(2006.01)i; ***H10K 50/12***(2023.01)i; ***H10K 50/125***(2023.01)i; ***H10K 50/15***(2023.01)i; ***H10K 50/16***(2023.01)i; ***H10K 50/18***(2023.01)i; ***H10K 59/10***(2023.01)i; ***H10K 59/12***(2023.01)i; ***H10K 85/60***(2023.01)i; *H10K 101/30*(2023.01)n; *H10K 101/40*(2023.01)n

FI: H10K50/13; G09F9/30 365; H10K50/12; H10K50/125; H10K50/15; H10K50/16; H10K50/18; H10K59/10; H10K59/12; H10K85/60; H10K101:30; H10K101:40

According to International Patent Classification (IPC) or to both national classification and IPC

### B. FIELDS SEARCHED

Minimum documentation searched (classification system followed by classification symbols)

H10K50/13; G09F9/30; H10K50/12; H10K50/125; H10K50/15; H10K50/16; H10K50/18; H10K59/10; H10K59/12; H10K85/60; H10K101/30; H10K101/40

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2020-21862 A (CANON KABUSHIKI KAISHA) 06 February 2020 (2020-02-06) paragraphs [0012], [0067]-[0080], [0092]-[0093], [0105]-[0126], [0130], [0140], fig. 1, fig. 3-9 | 1-20 |
| X<br>A | JP 2021-2655 A (CANON KABUSHIKI KAISHA) 07 January 2021 (2021-01-07) paragraphs [0020], [0071]-[0095], [0114]-[0143], [0149], [0153], [0159], fig. 1, 3-7 | 1-8, 10-20<br>9 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **13 March 2024** | **26 March 2024** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (July 2022)

**INTERNATIONAL SEARCH REPORT**

International application No.
**PCT/JP2024/002634**

**Box No. III Observations where unity of invention is lacking (Continuation of item 3 of first sheet)**

This International Searching Authority found multiple inventions in this international application, as follows:

(i) The number of inventions: 2
Claims 1-2 and 4-20
Claims 3-20

(ii) Reasons why the requirement of unity of invention is not complied with

1. Determination of subjected matters for examination on the basis of special technical features
The invention in claims 1-2 lacks novelty in light of the disclosure of document 1 or document 2 cited in the international search report, and does not have a special technical feature.
Thus, the invention in claims 1-2, for which the presence or absence of a special technical feature was previously determined, and the invention in claim 4-20, which has a special technical feature identical or corresponding to said special technical feature, are subject matters for examination.

2. Determination of subjected matters for examination on the basis of efficiency of examination
The invention of claim 3 is not an invention in the same category that includes all matters specifying the invention of claim 1. In addition, the invention in claim 3 and the invention in claims 4-20 referring to invention in claim 3 are not an invention that can be substantially examined without additional prior art search and judgment as a result of examining the invention subjected to examination on the basis of the special technical feature. Also, there are no other circumstances under which it would be efficient to examine the invention together with the invention.

The invention in claim 3 and the invention in claims 4-20 referring to the invention in claim 3 do not comply with the requirement of unity of invention.

1. ☐ As all required additional search fees were timely paid by the applicant, this international search report covers all searchable claims.

2. ☑ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**

☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet) (July 2022)

**INTERNATIONAL SEARCH REPORT**
**Information on patent family members**

International application No.
**PCT/JP2024/002634**

| Patent document cited in search report | Publication date (day/month/year) | Patent family member(s) | Publication date (day/month/year) |
|---|---|---|---|
| JP 2020-21862 A | 06 February 2020 | US 2020/0044175 A1<br>paragraphs [0023], [0094]-[0103], [0114], [0126]-[0147], [0150], [0157], fig. 1B, 3-9 | |
| JP 2021-2655 A | 07 January 2021 | US 2020/0403173 A1<br>paragraphs [0029], [0084]-[0101], [0128]-[0158], [0166], [0169], [0174], fig. 1A, 3-7B | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2019186521 A
- JP 2023015298 A
- JP 2023139102 A